# EUROPEAN PATENT APPLICATION

(11) **EP 4 253 126 A1**
(43) Date of publication of application: **04.10.2023**
(21) Application number: 23164377.6
(22) Date of filing: 27.03.2023
(51) Int. Cl.: B60L 50/75, B60L 58/00, G01R 31/382, G01R 31/392, G01R 31/396

(54) **SUSTAINING STATE OF CHARGE AND STATE OF HEALTH IN FUEL CELL MODULES AND BATTERIES OF A FUEL CELL HYBRID SYSTEM**

(30) Priority: 28.03.2022 US 202263324430 P
(71) Applicant: Cummins, Inc., Columbus, Indiana 47201 (US); Hydrogenics Corporation, Mississauga, ON L5T 2N6 (CA)
(72) Inventor: TURLAPATI, Agneya, Indianapolis, 46202 (US); RAUT, Akshat Abhay, Columbus, 47201 (US); RAY, Arka Saha, 411057 Pune (IN); PURI, Anant, Greenwood, 46143 (US); GENTER, David P., Columbus, 47201 (US); BEINBORN, Aaron William, Greenwood, 46142 (US); CHANDRARAJ, Joseph P., Austin, 78732 (US); TRIPATHI, Sumit, Columbus, 47201 (US); LEE, Heonjoong, Columbus, 47201 (US)
(74) Representative: Bryer, Pamela Ruth

(57) **Abstract**

A system for a fuel cell vehicle including a plurality of fuel cell modules, a plurality of battery packs, and a controller. At least one of the plurality of fuel cell modules having a state of health (SOH) different from a corresponding SOH of other fuel cell modules. Each battery pack including a plurality of battery cells. At least one of the plurality of battery packs having a SOH different from a corresponding SOH of other battery packs. The controller is communicatively coupled to monitor and control operation of the plurality of fuel cell modules and the plurality of battery packs. The controller is configured to receive a power demand and determine a power split between the plurality of fuel cell modules and the plurality of battery packs based on an operating phase of the vehicle.

## Description

### CROSS-REFERENCE TO RELATED APPLICATIONS

This non-provisional application claims the benefit and priority, under 35 U.S.C. § 119(e) and any other applicable laws or statutes, to U.S. Provisional Patent Application Serial No. 63/324,430 filed March 28, 2022, the entire disclosure of which is hereby expressly incorporated herein by reference.

### TECHNICAL FIELD

The present disclosure generally relates to achieving and maintaining a predefined state of charge (SOC) operation for a battery pack of a fuel cell system.

### BACKGROUND

Fuel cell systems are known for their efficient use of fuel to develop direct current (DC) electric power. A fuel cell produces electricity by electrochemically combining a fuel and an oxidant across an ionic conducting layer, the electrolyte, for which many fuel cells are named. Individual fuel cells may be interconnected in series or in parallel and assembled to form a fuel cell stack configured to produce electrical power to support a specific application.

### SUMMARY

Embodiments of the present invention are included to meet these and other needs.

In one aspect, described herein, a system for a fuel cell vehicle comprises a plurality of fuel cell modules, a plurality of battery packs, and a controller. At least one of the plurality of fuel cell modules has a state of health (SOH) different from a corresponding SOH of another fuel cell module in the plurality of fuel cell modules. Each battery pack includes a plurality of battery cells. At least one of the plurality of battery packs has a SOH different from a corresponding SOH of another battery pack in the plurality of battery packs. The controller is communicatively coupled to the plurality of fuel cell modules and the plurality of battery packs. The controller is configured to monitor and control operation of the plurality of fuel cell modules or the plurality of battery packs. The controller is configured to receive a power demand of the vehicle. The controller is configured to determine a power split between the plurality of fuel cell modules and the plurality of battery packs based on an operating phase of the vehicle. The controller is configured to cause a flow of power based on a determined power split from the plurality of fuel cell modules and from the plurality of battery packs to meet the power demand.

In some embodiments, the controller may be configured to determine the power split based on at least one of the SOH of the plurality of battery packs, the SOH of the plurality of fuel cell modules, and a state of charge (SOC) of the plurality of battery packs. In some embodiments, the plurality of battery cells may be combined to provide a plurality of battery modules, and wherein a SOH of at least one of the plurality of battery modules may be different from a SOH of at least one other of the plurality of battery modules.

In some embodiments, the controller may be configured to, in response to the power demand being greater than a threshold, determine an even power split between the plurality of fuel cell modules and the plurality of battery packs and may cause the flow of power from the plurality of fuel cells modules and the plurality of battery packs to power a traction motor to propel the vehicle. In some embodiments, the even power split may be determined further in response to detecting that the vehicle is moving up an incline.

In some embodiments, the controller may be configured to, in response to input parameters, determine a vehicle operational state, determine a battery power rate based on a relational or lookup model, and may cause at least one of the events of powering a traction motor to propel the vehicle, powering vehicle accessory systems, or causing the plurality of fuel cell modules to charge the plurality of battery packs. In some embodiments, the controller may be configured to cause the plurality of fuel cell modules to charge the plurality of battery packs further in response to detecting a truck bed of the vehicle is active. In some embodiments, the controller may be configured to determine a battery SOH correction factor to be used in determining the power split between the plurality of fuel cell modules and the plurality of battery packs.

According to a second aspect, described herein, a method for a fuel cell vehicle comprises receiving values of a plurality of input parameters, an actual state of health (SOH) of a battery, and a state of charge (SOC) of the battery, determining an operating state of the vehicle, determining a battery SOH correction factor, determining a power split between a plurality of fuel cell modules and the battery, and causing a flow of power from the plurality of fuel cell modules and to and from the battery based on the determined power split.

In some embodiments, the method may further comprise, in response to determining that the operating state of the vehicle is one of an idle state, a standby state, or a stationary state, determining a battery charge rate for charging the battery while the vehicle is in the idle state, the standby state, or the stationary state. In some embodiments, the method may further comprise, in response to determining that the operating state of the vehicle is a moving state, determining a battery charge rate for charging the battery while the vehicle is moving.

In some embodiments, the plurality of input parameters may include one of an actual battery SOC, a target battery SOC, a battery temperature, a battery voltage, a battery current, an ambient temperature, and an ambient pressure. In some embodiments, the power split may be determined based on a predictive fuel cell power demand estimation. In some embodiments, the predictive fuel cell power demand estimation may be provided by a cloud-based analytical system. In some embodiments, the cloud-based analytical system may determine the predictive fuel cell power demand estimation based on values of one of a speed of the vehicle, a weight of the vehicle, wheel power, a configuration of the vehicle, an ambient temperature, an upcoming route target speed, an upcoming route target grade, and an accessory power.

### BRIEF DESCRIPTION OF THE DRAWINGS

The detailed description particularly refers to the following figures, in which:
FIG. 1A is a schematic view of an exemplary fuel cell system including an air delivery system, a hydrogen delivery system, and a fuel cell module including a stack of multiple fuel cells;
FIG. 1B is a cutaway view of an exemplary fuel cell system including an air delivery system, hydrogen delivery systems, and a plurality of fuel cell modules each including multiple fuel cell stacks;
FIG. 1C is a perspective view of an exemplary repeating unit of a fuel cell stack of the fuel cell system of FIG. 1A;
FIG. 1D is a cross-sectional view of an exemplary repeating unit of the fuel cell stack of FIG. 1C;
FIG. 2A is a block diagram illustrating an example implementation of a fuel cell vehicle;
FIG. 2B is a block diagram illustrating the example fuel cell vehicle for specialized off- highway/on-highway applications;
FIG. 3 is a block diagram illustrating an example control system for controlling the fuel cell vehicle of FIG. 2A;
FIG. 4 is a graph illustrating a change in speed of the fuel cell vehicle of FIG. 2A with respect to time during an example operating cycle M;
FIG. 5 is a graph illustrating a change in elevation of the fuel cell vehicle of FIG. 2A with respect to time during the example operating cycle M;
FIG. 6 is a graph illustrating a flow of power from the fuel cell stack and to and from a battery of the fuel cell vehicle of FIG. 2A;
FIG. 7 is a graph illustrating a change in a state of charge (SOC) of the battery of the fuel cell vehicle of FIG. 2A;
FIGS. 8, 9 and 10 are block diagrams illustrating control strategies applied in response to a change in power demand during the example operating cycle M;
FIG. 11 is a block diagram illustrating an example power control system in accordance with the present disclosure;
FIG. 12 is a block diagram illustrating an example implementation of the power control system of FIG. 11 configured to communicate with a cloud network;
FIGS. 13, 14, 15, and 16 are block diagrams illustrating an open loop control strategy, a closed loop control strategy, a hybrid control strategy, and another hybrid control strategy, respectively, for a fuel cell controller of the fuel cell vehicle of FIG. 2A;
FIG. 17 is a graph illustrating a change in fuel efficiency of a fuel cell module with respect to a change in fuel cell module power; and
FIG. 18 is a block diagram illustrating an example process flow for controlling power flow from the fuel cell stack and to and from the battery of the fuel cell vehicle of FIG. 2A.

### DETAILED DESCRIPTION

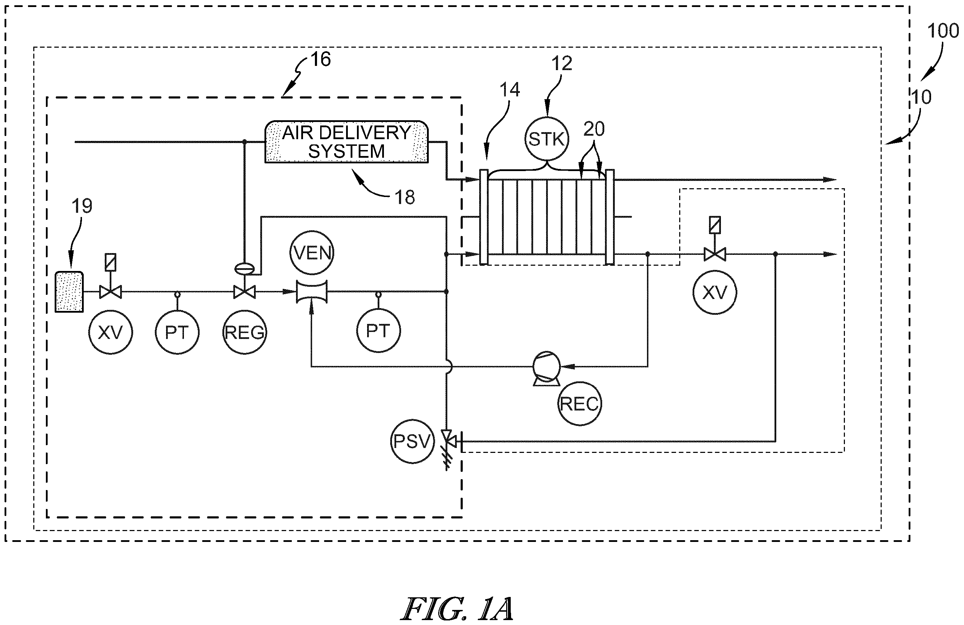

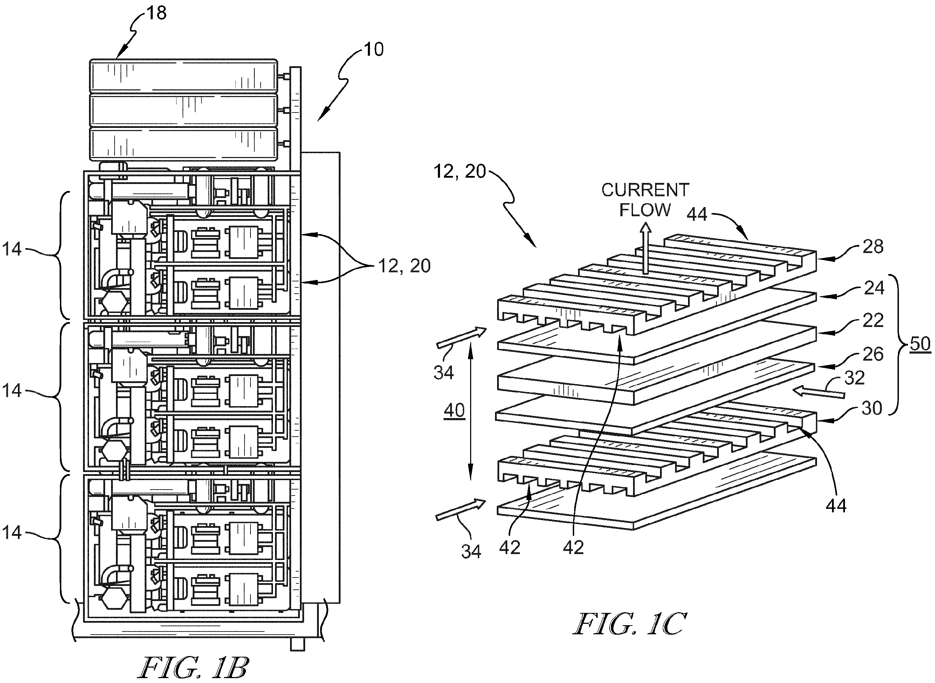

As shown in FIG. 1A, fuel cell systems **10** often include one or more fuel cell stacks **12** or fuel cell modules **14** connected to a balance of plant (BOP) **16,** including various components, to support the electrochemical conversion, generation, and/or distribution of electrical power to help meet modern day industrial and commercial needs in an environmentally friendly way. As shown in FIGS. 1B and 1C, fuel cell systems **10** may include fuel cell stacks **12** comprising a plurality of individual fuel cells **20.** Each fuel cell stack **12** may house a plurality of fuel cells **20** assembled together in series and/or in parallel. The fuel cell system **10** may include one or more fuel cell modules **14** as shown in FIGS. 1A and 1B.

Each fuel cell module **14** may include a plurality of fuel cell stacks **12** and/or a plurality of fuel cells **20.** The fuel cell module **14** may also include a suitable combination of associated structural elements, mechanical systems, hardware, firmware, and/or software that is employed to support the function and operation of the fuel cell module **14.** Such items include, without limitation, piping, sensors, regulators, current collectors, seals, and insulators.

The fuel cells **20** in the fuel cell stacks **12** may be stacked together to multiply and increase the voltage output of a single fuel cell stack **12.** The number of fuel cell stacks **12** in a fuel cell system **10** can vary depending on the amount of power required to operate the fuel cell system **10** and meet the power need of any load. The number of fuel cells **20** in a fuel cell stack **12** can vary depending on the amount of power required to operate the fuel cell system **10** including the fuel cell stacks **12.**

The number of fuel cells **20** in each fuel cell stack **12** or fuel cell system **10** can be any number. For example, the number of fuel cells **20** in each fuel cell stack **12** may range from about 100 fuel cells to about 1000 fuel cells, including any specific number or range of number of fuel cells **20** comprised therein (e.g., about 200 to about 800). In an embodiment, the fuel cell system **10** may include about 20 to about 1000 fuel cells stacks **12,** including any specific number or range of number of fuel cell stacks **12** comprised therein (e.g., about 200 to about 800). The fuel cells **20** in the fuel cell stacks **12** within the fuel cell module **14** may be oriented in any direction to optimize the operational efficiency and functionality of the fuel cell system **10.**

The fuel cells **20** in the fuel cell stacks **12** may be any type of fuel cell **20.** The fuel cell **20** may be a polymer electrolyte membrane or proton exchange membrane (PEM) fuel cell, an anion exchange membrane fuel cell (AEMFC), an alkaline fuel cell (AFC), a molten carbonate fuel cell (MCFC), a direct methanol fuel cell (DMFC), a regenerative fuel cell (RFC), a phosphoric acid fuel cell (PAFC), or a solid oxide fuel cell (SOFC). In an exemplary embodiment, the fuel cells **20** may be a polymer electrolyte membrane or proton exchange membrane (PEM) fuel cell or a solid oxide fuel cell (SOFC).

In an embodiment shown in FIG. 1C, the fuel cell stack **12** includes a plurality of proton exchange membrane (PEM) fuel cells **20.** Each fuel cell **20** includes a single membrane electrode assembly (MEA) **22** and a gas diffusion layers (GDL) **24, 26** on either or both sides of the membrane electrode assembly (MEA) **22** (see FIG. 1C). The fuel cell **20** further includes a bipolar plate (BPP) **28, 30** on the external side of each gas diffusion layers (GDL) **24, 26,** as shown in FIG. 1C. The above-mentioned components, in particular the bipolar plate **30,** the gas diffusion layer (GDL) **26,** the membrane electrode assembly (MEA) **22,** and the gas diffusion layer (GDL) **24** comprise a single repeating unit **50.**

The bipolar plates (BPP) **28, 30** are responsible for the transport of reactants, such as fuel **32** (e.g., hydrogen) or oxidant **34** (e.g., oxygen, air), and cooling fluid **36** (e.g., coolant and/or water) in a fuel cell **20.** The bipolar plates (BPP) **28, 30** can uniformly distribute reactants **32, 34** to an active area **40** of each fuel cell **20** through oxidant flow fields **42** and/or fuel flow fields **44** formed on outer surfaces of the bipolar plates (BPP) **28, 30.** The active area **40,** where the electrochemical reactions occur to generate electrical power produced by the fuel cell **20,** is centered, when viewing the stack **12** from a top-down perspective, within the membrane electrode assembly (MEA) **22,** the gas diffusion layers (GDL) **24, 26,** and the bipolar plate (BPP) **28, 30.**

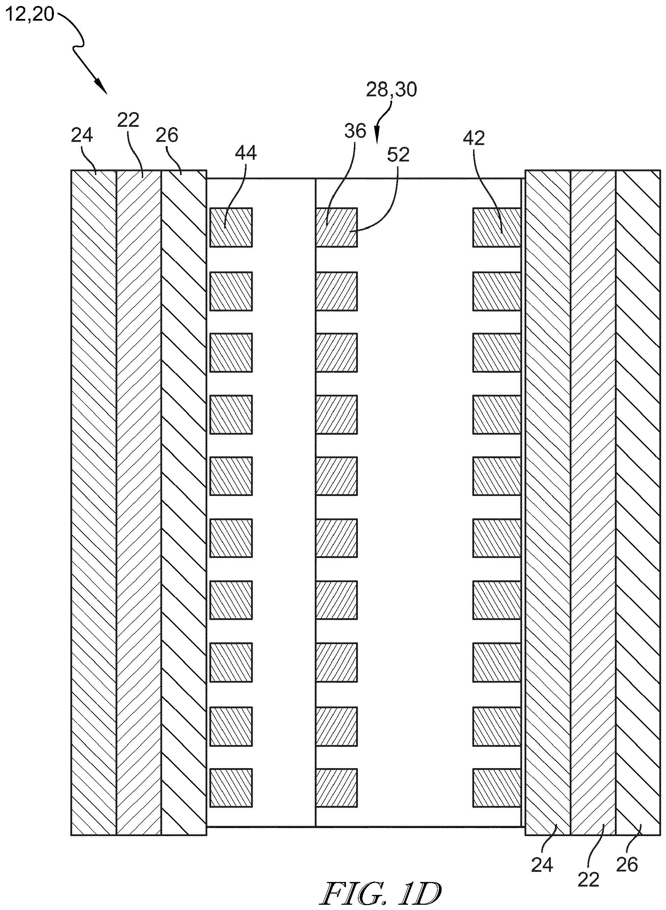

The bipolar plates (BPP) **28, 30** may each be formed to have reactant flow fields **42, 44** formed on opposing outer surfaces of the bipolar plate (BPP) **28, 30,** and formed to have coolant flow fields **52** located within the bipolar plate (BPP) **28, 30,** as shown in FIG. 1D. For example, the bipolar plate (BPP) **28, 30** can include fuel flow fields **44** for transfer of fuel **32** on one side of the plate **28, 30** for interaction with the gas diffusion layer (GDL) **26,** and oxidant flow fields **42** for transfer of oxidant **34** on the second, opposite side of the plate **28, 30** for interaction with the gas diffusion layer (GDL) **24.** As shown in FIG. 1D, the bipolar plates (BPP) **28, 30** can further include coolant flow fields **52** formed within the plate (BPP) **28, 30,** generally centrally between the opposing outer surfaces of the plate (BPP) **28, 30.** The coolant flow fields **52** facilitate the flow of cooling fluid **36** through the bipolar plate (BPP) **28, 30** in order to regulate the temperature of the plate (BPP) **28, 30** materials and the reactants. The bipolar plates (BPP) **28, 30** are compressed against adjacent gas diffusion layers (GDL) **24, 26** to isolate and/or seal one or more reactants **32, 34** within their respective pathways **44, 42** to maintain electrical conductivity, which is required for robust operation of the fuel cell **20** (see FIGS. 1C and 1D).

The fuel cell system **10** described herein, may be used in stationary and/or immovable power system, such as industrial applications and power generation plants. The fuel cell system **10** may also be implemented in conjunction with an air delivery system **18.** Additionally, the fuel cell system **10** may also be implemented in conjunction with a hydrogen delivery system and/or a source of hydrogen **19** such as a pressurized tank, including a gaseous pressurized tank, cryogenic liquid storage tank, chemical storage, physical storage, stationary storage, an electrolysis system, or an electrolyzer. In one embodiment, the fuel cell system **10** is connected and/or attached in series or parallel to a hydrogen delivery system and/or a source of hydrogen **19,** such as one or more hydrogen delivery systems and/or sources of hydrogen **19** in the BOP **16** (see FIG. 1A). In another embodiment, the fuel cell system **10** is not connected and/or attached in series or parallel to a hydrogen delivery system and/or a source of hydrogen **19.**

The present fuel cell system **10** may also be comprised in mobile applications. In an exemplary embodiment, the fuel cell system **10** is in a vehicle and/or a powertrain **100.** A vehicle **100** comprising the present fuel cell system **10** may be an automobile, a pass car, a bus, a truck, a train, a locomotive, an aircraft, a light duty vehicle, a medium duty vehicle, or a heavy-duty vehicle. Type of vehicles **100** can also include, but are not limited to commercial vehicles and engines, trains, trolleys, trams, planes, buses, ships, boats, and other known vehicles, as well as other machinery and/or manufacturing devices, equipment, installations, among others.

The vehicle and/or a powertrain **100** may be used on roadways, highways, railways, airways, and/or waterways. The vehicle **100** may be used in applications including but not limited to off highway transit, bobtails, and/or mining equipment. For example, an exemplary embodiment of mining equipment vehicle **100** is a mining truck or a mine haul truck.

In addition, it may be appreciated by a person of ordinary skill in the art that the fuel cell system **10,** fuel cell stack **12,** and/or fuel cell **20** described in the present disclosure may be substituted for any electrochemical system, such as an electrolysis system (e.g., an electrolyzer), an electrolyzer stack, and/or an electrolyzer cell (EC), respectively. As such, in some embodiments, the features and aspects described and taught in the present disclosure regarding the fuel cell system **10,** stack **12,** or cell **20** also relate to an electrolyzer, an electrolyzer stack, and/or an electrolyzer cell (EC). In further embodiments, the features and aspects described or taught in the present disclosure do not relate, and are therefore distinguishable from, those of an electrolyzer, an electrolyzer stack, and/or an electrolyzer cell (EC).

Accordingly, the fuel cell system **10** of the present disclosure may include one or more fuel cell modules **14** and/or one or more fuel cell stacks **12** that generate power in a manner far more environmentally friendly than conventional power systems, such as, an internal combustion engine (ICE). The fuel cell system **10,** the one or more fuel cell modules **14,** and/or the one or more fuel cell stacks **12** of the present disclosure may comprise one or more fuel cells **20.** The fuel cell **20** or the one or more fuel cell modules **14** produces electricity by electrochemically combining the fuel **32** and the oxidant **34** across the bipolar plates (BPP) **28, 30.**

Fuel cells **20** may be electrically coupled in series into assemblies (e.g., fuel cell stacks **12)** to produce power at useful voltages or currents. Therefore, interconnected structures are used to connect or couple adjacent fuel cells **20** in series or in parallel to form a fuel cell stack **12** or a fuel cell module **14.** Hardware components used to incorporate an MEA **22** into a fuel cell **20** include gaskets, which provide a seal around the MEA **22** to prevent leakage of gases, and bipolar plates **28, 30,** which are used to assemble individual fuel cells **20** into a fuel cell stack **12** and provide channels for the gaseous fuel **32** and air **34.**

The fuel cell system **10** may include the balance of plant (BOP) **16.** In one example, components of the fuel cell system **10** may be configured to couple to the BOP **16.** In another example, the fuel cell system **10** may include additional components, features, or systems to operate valves and other components to control pressure (e.g., fluid or air pressure), heating and cooling, water condensation, temperature, exhaust, humidity, and other operating parameters of the fuel cell system **10.** In some embodiments, the BOP **16** of the fuel cell system **10** further comprises one or more valve control systems, fluid control and/or air handling systems, pressure control systems, heating and/or cooling systems, exhaust systems, fuel handling and/or delivery systems, temperature, water, and/or humidity control systems, and wiring and/or electronic systems, including external power electronics systems.

A typical duty cycle of the mining equipment vehicle **100** includes periods of high power load, e.g., when the vehicle **100** is climbing an incline and/or hauling a full payload, and periods of low power load, e.g., when the vehicle **100** is traveling downhill and/or traveling empty. As in mining, power load of the vehicle **100** in power generation applications may vary significantly during a given operating cycle. However, without adequate power management, providing sufficient power to such high capacity vehicles **100** that operate under highly variable power loads may require oversizing a battery system by providing additional, or larger, battery packs **158,** which, in turn, may increase vehicle **100** fuel consumption and other inefficiencies.

The systems and methods of the present disclosure provide effective management of one or more of the plurality of onboard fuel cell modules **14** to charge the plurality of battery packs **158** of the fuel cell vehicle **100** during different operating states of the vehicle **100.** While the present system and method may be used at any time of operation, exemplary operation states of the vehicle **100** where the present system and method may be utilized includes during an idle operating state, a loading and unloading operating state, and a moving operating state. In this manner, the system is configured to utilize lower demand sections of the route of the vehicle **100** to keep the plurality of battery packs **158** sufficiently charged and ready for when high power is needed. The system is configured to ensure that a charge level of the plurality of battery packs **158** is maintained at a predefined target charge level during predefined operating conditions. Predefined operating conditions occur during conditions of sustained power demand P from the fuel cell vehicle **100** when combined power from both the plurality of fuel cell modules **14** and the plurality of battery packs **158** is needed. As some examples, operating conditions that may demand combined power from both the plurality of fuel cell modules **14** and the plurality of battery packs **158** include sustained acceleration events and long or extended hill climbs.

During normal operation, the fuel cells **20** and the plurality of fuel cell modules **14,** such as those used in vehicles **100** and/or powertrains **100,** continuously age, degrade, and/or deteriorate over time. Degradation rate may vary between each fuel cell **20,** e.g., fuel cells **20** near the edges of the fuel cell module **14** may, in some instances, degrade faster. Such aging, degradation, and deterioration may affect performance of one or more stack components, such as the single membrane electrode assembly **22,** the bipolar plates **28, 30,** the gas diffusion layers **24, 26.** This aging, degradation, and/or deterioration may shorten a useful operating lifecycle of the plurality of fuel cell modules **14** or the fuel cell stack **12** as a whole.

Further, certain modes of operation, charge and discharge rates, as well as operating conditions of the fuel cell **20,** may accelerate or slow aging and degradation processes within the plurality of fuel cell modules **14.** Parameters used to track degradation and aging of the fuel cells **20** may be a state of health (SOH), remaining useful life (RUL), and others. Put another way, a state of performance degradation of a given fuel cell module **14** or a portion of a fuel cell module **14** may be referred to, quantitated, and/or measured as a SOH of that fuel cell module **14** or a portion of fuel cell module **14.**

Where multiple fuel cell stacks **12** and/or fuel cell modules **14** having multiple fuel cell stacks **12** are present, portions (e.g., fuel cells **20,** stacks of cells **12)** of the fuel cell module **14** or one or more of the plurality of fuel cell modules **14** of the fuel cell vehicle **100** may be replaced at different times and/or may degrade at a different rate. Accordingly, the fuel cell system **10** of a given fuel cell vehicle **100** may include one or more fuel cell modules **14** or portions of the fuel cell modules **14** having different states of performance degradation, or changes in operating efficiency from that of a new unit, such as a different SOH from that of one another.

In mining, power generation, and other applications, the plurality of battery packs **158** of vehicles **100** or systems may include multiple battery packs **158** and/or battery packs **158** having multiple battery modules. In some instances, portions (e.g., cells, modules of cells) of a battery pack **158** or one or more battery packs **158** of the fuel cell vehicle **100** may be replaced at different times, such that a battery energy system of a given fuel cell vehicle **100** may include battery packs **158** or portions of battery packs **158** having different states of performance degradation, or changes in operating efficiency from that of a new unit.

A state of performance degradation of a given battery pack **158** or a portion of a battery pack **158** may be referred to as a SOH of that battery pack **158** or a portion of that battery pack **158.** Accordingly, a SOH of a given battery pack **158** or a portion of a battery pack **158** may be different from a corresponding SOH of another battery pack **158** or a portion of a same or a different battery pack **158,** e.g., a battery module, and so on. The systems and methods of the present disclosure are configured to correct for differences in the SOH of the plurality of battery packs **158** and/or subcomponents of the battery packs **158,** such as modules or cells. For example, adjusting power demand to cause the fuel cell stack **12** to charge battery packs **158** having a SOH less than a threshold, while charging battery packs **158** having a SOH greater than a threshold during regenerative braking.

State of charge (SOC) of the battery packs **158** may be indicative of an amount of electrical energy stored in that battery pack **158** and may be a function of temperature, battery capacitance, and battery internal resistance among other parameters. Ability of the battery pack **158** to receive charge, provide charge (e.g., to discharge), and to maintain charge level may degrade as the battery pack **158** ages. Operating parameters and conditions of the battery pack **158** may affect (either slow or accelerate) aging and degradation process.

For example, preventing over-charge and/or over-discharge and improving the battery utilization rate of the battery pack **158** may minimize, slow, or prevent degradation of the battery cells, battery modules, and/or battery stacks. In some instances, degradation of performance of the battery pack **158** may be prevented or slowed by operating the battery pack **158** at a SOC between a predefined minimum and a predefined maximum SOC, e.g., from about 20% to about 90%, from about 20% to about 95%, from about 25% to about 90%, including any specific or range of percentages comprised therein. Accordingly, if the battery pack **158** is at around 20% SOC, the flow of power from the battery pack **158** should decrease, *i.e.,* power demand P of the vehicle **100** may be met using traction motors **162** until the SOC of the battery pack **158** rises above the 20% threshold.

The systems and methods of the present disclosure are configured to correct for differences in the SOC of the plurality of battery packs **158** and/or subcomponents of the battery packs **158,** such as modules or cells. For example, adjusting power demand to cause the fuel cell modules **14** to charge the battery packs **158** having a SOC less than a threshold, while charging the battery packs **158** having a SOC greater than a threshold during regenerative braking. The present systems and methods are described in further detail herein.

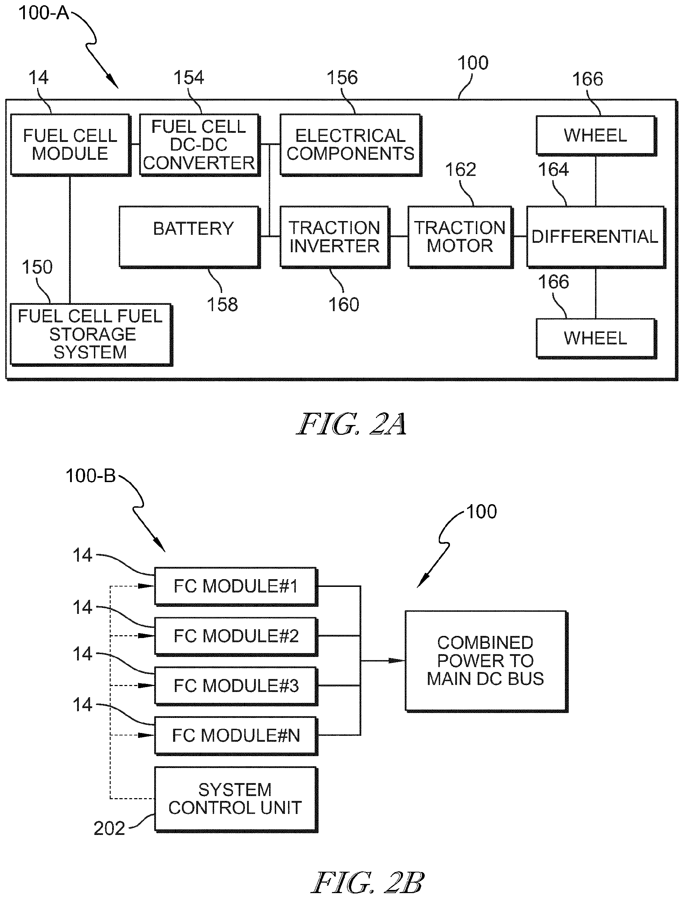

FIG. 2A illustrates an example implementation **100-A** of a fuel cell vehicle **100** in accordance with the present disclosure. While the vehicle **100** is illustrated and described in reference to FIG. 2A, the power control systems and methods disclosed herein are not so limited. Example applications of the systems and methods for controlling fuel cell system power flow in accordance with the present disclosure include, but are not limited to, stationary or semi-stationary applications in personal, residential, and/or industrial context. Example non-stationary applications of a humidification system and methods of the present disclosure include vehicular and mobile applications, whether operator-controlled, autonomous, or semi-autonomous, such as, but are not limited to, automobiles, vans, trucks (e.g., mining trucks), agricultural machinery and equipment, trains, marine vehicles, aircraft, spacecraft, satellite, and drone.

The example fuel cell vehicle **100** includes a fuel cell fuel storage system **150,** the plurality of fuel cell modules **14,** the plurality of battery packs (or battery packs) **158,** and/or the traction motor **162.** As illustrated in FIG. 2B, an example implementation **100-B** of the fuel cell vehicle **100** for specialized off-highway/on-highway applications, such as mining or power generation, may include the plurality of fuel cells **20** interconnected, or otherwise electrically or mechanically combined, to provide the plurality of fuel cell stacks **12,** that are, in turn, combined into the plurality of fuel cell modules **14.** Additionally or alternatively, the fuel cell vehicle **100** may include the plurality of battery packs **158.**

Referring back to FIG. 2A, the fuel cell fuel storage system **150** of the example fuel cell vehicle **100** provides fuel **32** (e.g., hydrogen, compressed natural gas (CNG)) for a fuel cell **20** or fuel cell stack **12** of the plurality of fuel cell modules **14.** The plurality of fuel cell modules **14** uses a chemical process to generate electrical energy. The electrical energy generated by the plurality of fuel cell modules **14** may be stored in the plurality of battery packs **158** for use by one or more propulsion or non-propulsion components of the example fuel cell vehicle **100.**

In some instances, a portion of the electrical energy generated by the plurality of fuel cell modules **14,** whether directly or via the plurality of battery packs **158,** may be used to power the traction motor **162** (see FIG. 2A). The traction motor **162** is mechanically coupled to a differential **164** that distributes power to one or more wheels **166** (e.g., about 1 to about 16 wheels) to operate the fuel cell vehicle **100.** In still other examples, a portion of the electrical energy generated by the plurality of fuel cell modules **14,** whether directly or via the plurality of battery packs **158,** may be transferred to power electrical components **156** of the fuel cell vehicle **100,** such as interior lighting, cabin cooling, and/or an infotainment system (e.g., TV/console/computer display system).

Referring again to FIG. 2A, a fuel cell DC-DC converter **154** steps up DC power output by the plurality of fuel cell modules **14** to a voltage compatible with the electrical components **156** and/or the plurality of battery packs **158.** A traction inverter **160** inverts DC power supplied by the plurality of battery packs **158** and/or by the plurality of fuel cell modules **14** to AC power compatible with the traction motor **162.** The traction inverter **160** may be bidirectional and may convert AC power output by the traction motor **162** operating in a generator mode to DC power for transfer to the plurality of battery packs **158.**

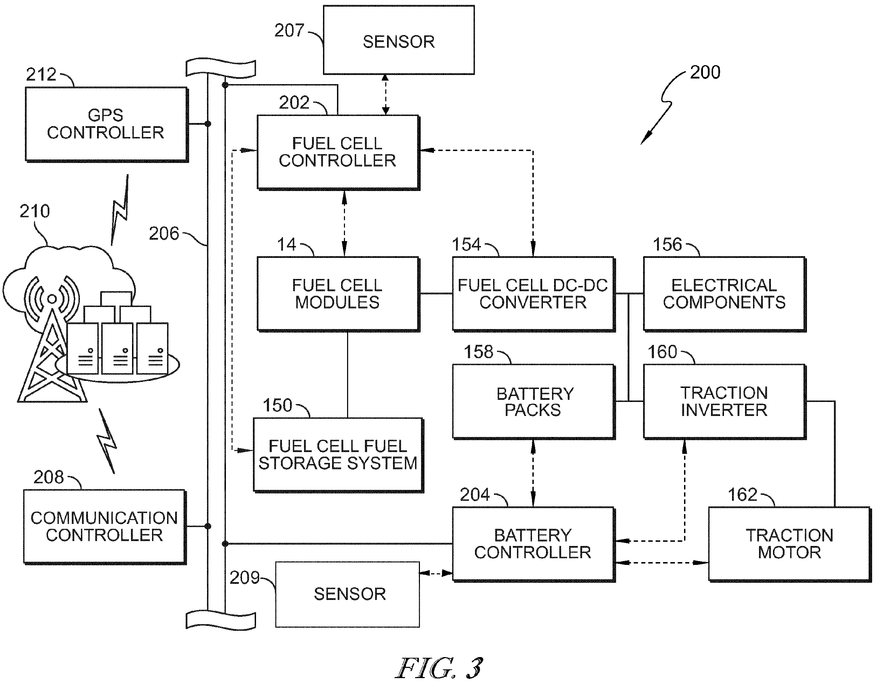

FIG. 3 illustrates an example control system **200** for controlling one or more components of the fuel cell vehicle **100** described in reference to FIG. 2A. The control system **200** includes a fuel cell controller **202** and a battery controller **204.** The fuel cell controller **202** may be communicatively coupled to and configured to monitor and control operation of the fuel cell fuel storage system **150,** the plurality of fuel cell modules **14,** and/or the fuel cell DC-DC converter **154.** The battery controller **204** may be communicatively coupled to and configured to monitor and control operation of the plurality of battery packs **158,** the traction inverter **160,** and/or the traction motor **162.**

Of course, in other implementations, one or more operations of the fuel cell controller **202** may be executed by the battery controller **204** and vice versa. In still other examples, one or more operations of the controllers **202, 204** may be executed by one or more other hybrid-vehicle-specific or conventional vehicle controllers, such as, for example, a vehicle system controller, an energy management controller, a regenerative braking controller, and/or an electrical system controller. To that end, the controllers **202, 204** may be communicatively coupled to a vehicle communication network **206** and configured to exchange data, signals, and/or action commands with one another and with other controllers of the vehicle **100.**

Each of the fuel cell controller **202** and the battery controller **204** may be communicatively coupled to and configured to receive signals from one or more sensors **207, 209.** Sensors **207, 209** may include any type of sensor, for example, temperatures sensors, pressure sensors, current sensors, and/or voltage sensors. The controllers **202, 204** are configured to control, based on one or more of a received sensor signal, operation of one or more components, systems, and/or subsystems of the vehicle **100,** such as the fuel cell fuel storage system **150,** the plurality of fuel cell modules **14,** the fuel cell DC-DC converter **154,** the plurality of battery packs **158,** the traction inverter **160,** and/or the traction motor **162,** as just some examples.

The vehicle **100** may include a communication controller **208** configured to establish communication between the vehicle **100** and a network **210.** The communication controller **208** may be configured to communicate via the network **210,** either periodically or in response to a corresponding signal from a controller **202, 204** of the vehicle **100,** to transmit and receive data indicating a vehicle operating state, vehicle lookahead data, and/or other information. The vehicle **100** may include a global positioning system (GPS) controller **212** configured to establish communication via the network **210** to receive geographic coordinates or other environmental or location information of the vehicle **100.**

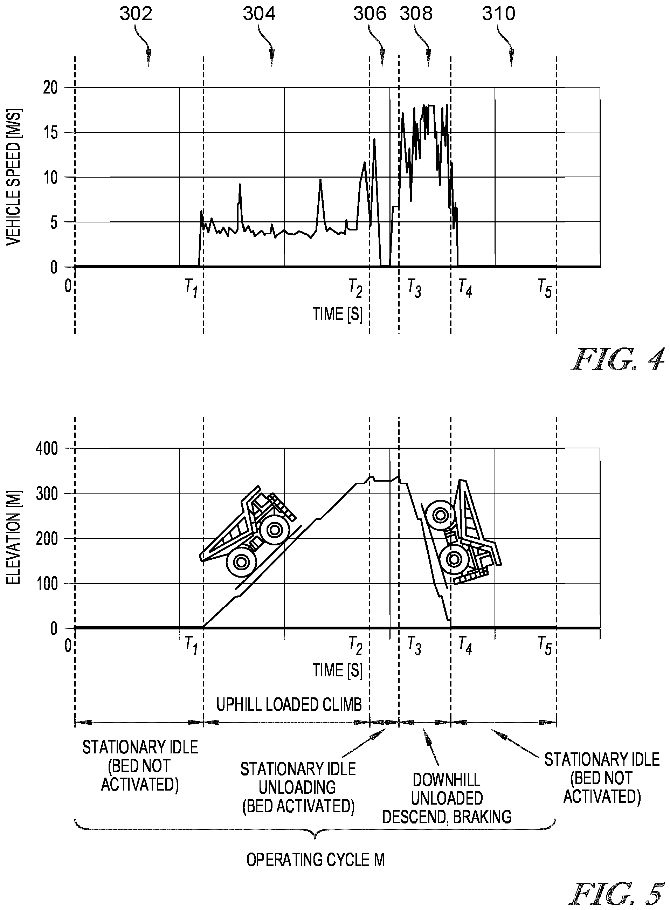

FIG. 4 is a graph illustrating a change in speed of the fuel cell vehicle **100** with respect to time during an example operating cycle M. FIG. 5 is a graph illustrating a change in elevation of the fuel cell vehicle **100** with respect to time during the example operating cycle M. The example operating cycle M of the vehicle **100** may include a first stationary idle loading phase **302,** an uphill loaded climbing phase **304,** a stationary idle unloading phase **306,** a downhill unloaded descending phase **308,** and/or a second stationary idle loading phase **310.** In some instances, phases **302, 304, 306, 308, 310** of the operating cycle M may be arranged in a different order or sequence or may be repeated. In some other instances, the operating cycle M may include fewer, more, or a different combination of phases.

The fuel cell vehicle **100** may be said to be in one of the first and second stationary idle loading phases **302, 310** when the vehicle **100** is stationary, idling, and, if equipped with a truck bed, having an inactive truck bed, *i.e.,* from a time *t₀* to a time *t₁* and from a time *t*₄ to a time *t₅* of the graphs of FIGS. 4 and 5, respectively. Whether the fuel cell vehicle **100** is stationary may be determined based on, for example, at least one of a transmission gear position, a speed of the vehicle **100,** and/or a speed of the wheel **166** of the vehicle **100.** Whether the fuel cell vehicle **100** is idling may be determined based on, for example, at least one of an ignition switch position, a transmission gear position, and/or a speed of the traction motor **162.** Whether a truck bed of the fuel cell vehicle **100** is inactive may be determined based on, for example, a position of the truck bed, a speed of the truck bed, and/or a positon of a switch controlling the truck bed.

The fuel cell vehicle **100** may be said to be in the uphill loaded climbing phase **304** when the vehicle **100** is moving up an incline with a predefined payload, *i.e.,* from a time *t₁* to a time *t₂* of the graphs of FIGS. 4 and 5. Whether the fuel cell vehicle **100** is moving may be determined based on, for example, at least one of a transmission gear position, a speed of the vehicle **100,** and/or an acceleration of the vehicle **100.** Whether the fuel cell vehicle **100** is traveling up an incline may be determined based on, for example, at least one of a change in elevation of the vehicle **100,** a power load of the traction motor **162,** and a speed and acceleration of the vehicle **100.** Whether the fuel cell vehicle **100** is carrying a payload may be determined based on, for example, a weight of the vehicle **100,** a power load of the traction motor **162,** and/or a speed and acceleration of the vehicle **100.**

The fuel cell vehicle **100** may be said to be in the stationary idle unloading phase **306** when the vehicle **100** is stationary, idling, and, if equipped with a truck bed, the truck bed of the vehicle **100** being active, *i.e.,* from a time *t₂* to a time *t₃* of the graphs of FIGS. 4 and 5. Whether the fuel cell vehicle **100** is stationary may be determined based, for example, on at least one of a transmission gear position, a speed of the vehicle **100,** and a speed of the wheel **166** of the vehicle **100.** Whether the fuel cell vehicle **100** is idling may be determined based on, for example, at least one of an ignition switch position, a transmission gear position, and/or a speed of the traction motor **162.** Whether a truck bed of the fuel cell vehicle **100** is active may be determined based on, for example, a position of the truck bed, a speed of the truck bed, and/or a positon of a switch controlling the truck bed.

The fuel cell vehicle **100** may be said to be in the downhill unloaded descending phase **308** when the vehicle **100** is moving down an incline without a payload, *i.e.,* from a time *t₃* to a time *t₄* of the graphs of FIGS. 4 and 5. Whether the fuel cell vehicle **100** is moving may be determined based on, for example, at least one of a transmission gear position, a speed of the vehicle **100,** and/or an acceleration of the vehicle **100.** Whether the fuel cell vehicle **100** is traveling down an incline may be determined based on, for example, at least one of a change in elevation of the vehicle **100,** a power load of the traction motor **162,** and/or a speed and acceleration of the vehicle **100.** Whether the fuel cell vehicle **100** is carrying a payload may be determined based on, for example, a weight of the vehicle **100,** a power load of the traction motor **162,** and/or a speed and acceleration of the vehicle **100.**

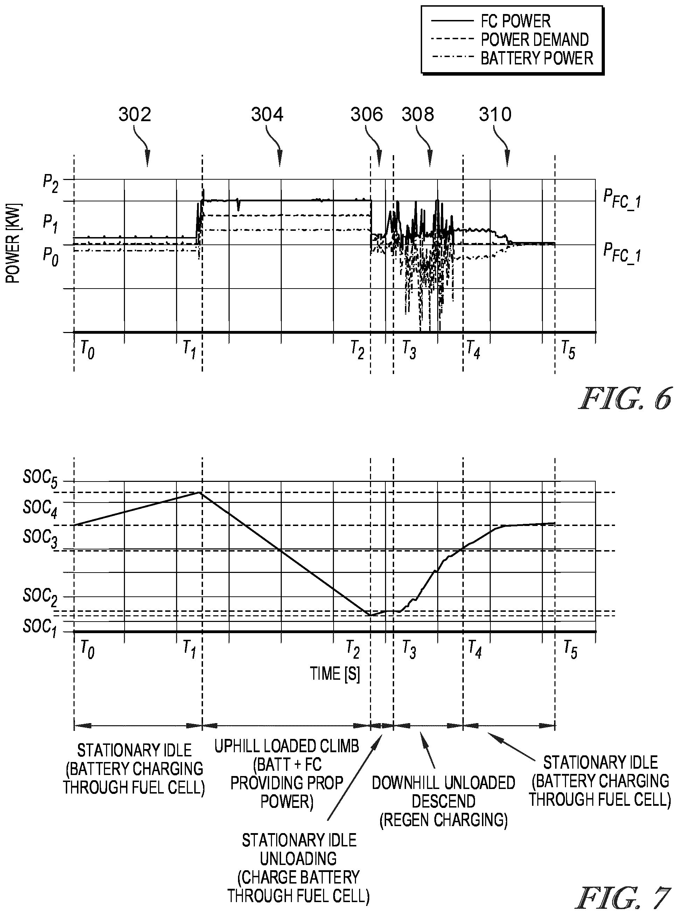

FIG. 6 is a graph illustrating a flow of power from the plurality of fuel cell modules **14** to and from the plurality of battery packs **158** of the fuel cell vehicle **100** with a change in power demand P of the vehicle **100** during each of the phases **302, 304, 306, 308, 310** of the example operating cycle M. FIG. 7 is a graph illustrating a change in the SOC of the plurality of battery packs **158** of the fuel cell vehicle **100** during each of the phases **302, 304, 306, 308, 310** of the example operating cycle M. The SOC of the plurality of battery packs **158** depends on the battery chemistry of a particular battery pack **158.**

In one example, a power demand P of the vehicle **100** may be between about 0 kW and about 100 kW, including any specific or range of kW comprised therein, during the first stationary idle loading phase **302.** As shown in FIG. 7, the fuel cell controller **202** may cause the plurality of fuel cell modules **14** to charge the plurality of battery packs **158** during the first stationary idle loading phase **302** to increase the SOC of the battery packs **158** from *S0C₄* to *SOC₅.*

As another example (see FIGS. 6 and 7), a power demand P of the vehicle **100** may be greater than or equal to about 1200 kW during the uphill loaded climbing phase **304.** The fuel cell controller **202** and the battery controller **204** may be configured to cause the plurality of fuel cell modules **14** and the plurality of battery packs **158** to provide energy to achieve the power demand value *P₂.* The SOC of the plurality of battery packs **158** may decrease from *SOC₅* to *SOC₁* during the uphill loaded climbing phase **304.**

As still another example, a power demand P of the vehicle **100** may be between about 300 kW and about 1200 kW, including any specific or range of kW comprised therein, during the stationary idle unloading phase **306.** The fuel cell controller **202** may be configured to cause the plurality of fuel cell modules **14** to charge the plurality of battery packs **158** during the stationary idle unloading phase **306** to increase the SOC of the plurality of battery packs **158** from *SOC₁* to *SOC₂.*

As yet another example, a power demand P of the vehicle **100** may be between about 0 kW and about 300 kW, including any specific or range of kW comprised therein, during the downhill unloaded descending phase **308.** The fuel cell controller **202** may cause the plurality of fuel cell modules **14** to charge the plurality of battery packs **158** during the downhill unloaded descending phase **308** to increase the SOC of the plurality of battery packs **158** from *SOC₂* to *SOC₃.*

As still another example, a power demand P of the vehicle **100** may be between about 0 kW and about 100 kW, including any specific or range of kW comprised therein, during the second stationary idle loading phase **310.** The fuel cell controller **202** may cause the plurality of fuel cell modules **14** to charge the plurality of battery packs **158** to increase the SOC of the plurality of battery packs **158** from *SOC₃* to *SOC₄* during the second stationary idle loading phase **310** (see FIGS. 6 and 7).

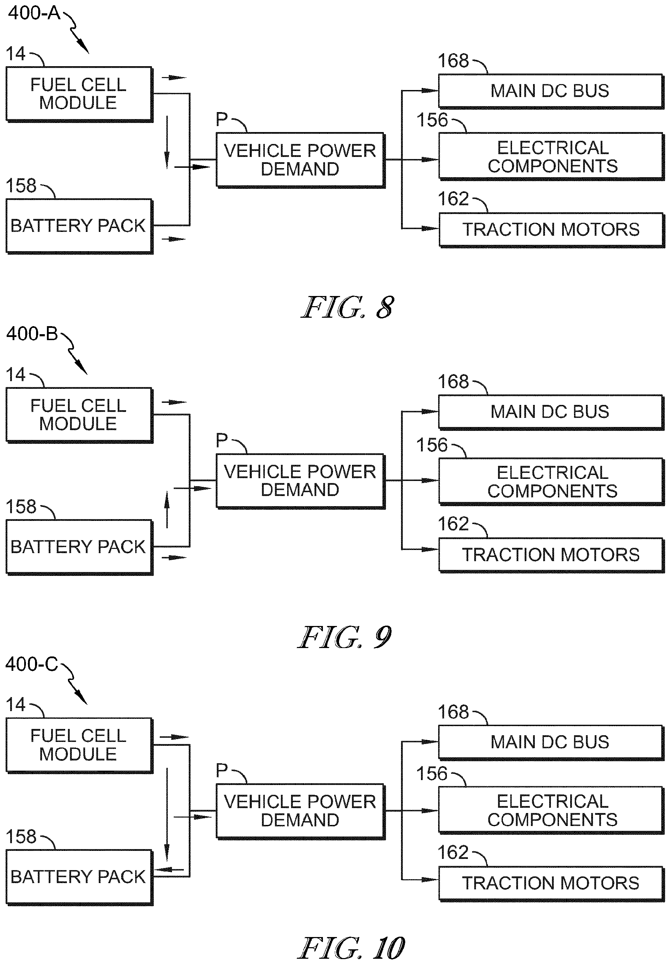

FIGS. 8-10 illustrate diagrams of power control strategies that may be applied in response to a change in power demand P of the vehicle **100** during each of the phases **302, 304, 306, 308, 310** of the example operating cycle M.

In response to power demand P of the vehicle **100** being less than a predefined threshold (between about 0 kW and about 100 kW, including any specific or range of kW comprised therein) during the first and second stationary idle loading phases **302, 310** discussed in reference to at least FIGS. 4-7, the fuel cell controller **202** and the battery controller **204** may be configured to operate the plurality of fuel cell modules **14** and the plurality of battery packs **158,** respectively. The controllers **202, 204** may be configured to utilize at least one of a first strategy **400-A,** as shown in FIG. 8, a second strategy **400-B,** as shown in FIG. 9, and/or a third strategy **400-C,** as shown in FIG. 10.

More specifically, the first strategy **400-A** of the fuel cell controller **202** includes transferring power from the fuel cell modules **14** to the traction motor **162,** e.g., via the traction inverter **160** as shown in FIG. 8. This first strategy is implemented to achieve the power demand P of the vehicle **100,** turn down or decrease the use of the plurality of battery packs **158** due to the SOC of the plurality of battery packs **158** being less than a predefined threshold, and/or to conserve the SOH of the plurality of battery packs **158.** In some instances, turning down or decreasing the use of the plurality of battery packs **158** may include turning off, or otherwise temporarily disabling or inhibiting operation of the plurality of battery packs **158.** This decreased or disabled use of the battery packs ensures that the SOC of the plurality of battery packs **158** is maintained at the predefined threshold, e.g., such that the SOC of the plurality of battery packs **158** is between about 20% and about 100%, including any specific or range of percentages comprised therein.

In this manner, an excessive rate of degradation of the plurality of battery packs **158** may be prevented or slowed. In some instances, to help manage, reduce, and/or prevent the degradation rate of the plurality of battery packs **158** to achieve longevity of the operation of the plurality of battery packs **158,** the plurality of battery packs **158** may be designed to operate at a SOC between about 20% and about 90%, including any specific or range of percentages comprised therein. Accordingly, if the plurality of battery packs **158** is at about 20% SOC, the flow of power from the plurality of battery packs **158** should decrease, *i.e.,* power demand P of the vehicle **100** may be met using the plurality of fuel cell modules **14** and traction motors **162** until the SOC of the plurality of battery packs **158** is sufficiently above the 20% threshold.

The second strategy **400-B** applied by the fuel cell controller **202** and the battery controller **204** during the first and second stationary idle loading phases **302, 310** is shown in FIG. 9. This second strategy **400-B** includes causing the plurality of battery packs **158** to provide power to the traction motors **162** and to the vehicle **100** while turning down the use of the plurality of fuel cell modules **14** to conserve fuel cell fuel **32** (e.g., hydrogen) to optimize fuel economy.

The third strategy **400-C** of the fuel cell controller **202** that may be applied during the first and second stationary idle loading phases **302, 310** is shown in FIG. 10. This third strategy **400-C** includes transferring power from the plurality of fuel cell modules **14** to the plurality of battery packs **158** and the traction motors **162,** such that a higher fuel cell **20** power may be used to charge the plurality of battery packs **158** to maintain a target SOC operation, while at the same time providing power to the vehicle **100.**

Moreover, the control strategy and power flow **400-A** described with reference to FIG. 8 may be applied in response to power demand P of the vehicle **100** being between about 300 kW and about 1200 kW, including any specific or range of kW comprised therein, such as during the stationary idle unloading phase **306** discussed in reference to at least FIGS. 4-7 and/or during traveling on a level (flat) grade. In addition to the first, second, and third control strategies **400-A, 400-B, 400-C** described above, respectively, in reference to the vehicle **100** operating in the first and second stationary idle loading phases **302, 310,** the fuel cell controller **202** may apply a fourth control strategy during the stationary idle unloading phase **306** and/or during traveling on a level (flat) grade. The fourth control strategy may include causing both the plurality of fuel cell modules **14** and the plurality of battery packs **158** to provide power to the traction motor **162** to actuate the truck bed during unloading. Alternatively, this fourth control strategy may be utilized to propel the vehicle **100** traveling on a level grade and may improve maintaining a target SOC and a target SOH for components of the fuel cell vehicle **100.**

With reference to FIG. 9, in response to power demand P of the vehicle **100** being greater than or equal to about 1200 kW, during the uphill loaded climbing phase **304** discussed in reference to at least FIGS. 4-7, the fuel cell controller **202** and the battery controller **204** may be configured to operate the plurality of fuel cell modules **14** and the plurality of battery packs **158,** respectively, to maintain a target SOC and a target SOH for components of the fuel cell vehicle **100.**

With reference to FIG. 10, in response to power demand P of the vehicle **100** being between about 0 kW and about 100 kW, including any specific or range of kW comprised therein, and/or braking power being between about 0 kW and about 3000 kW, including any specific or range of kW comprised therein, such as during the downhill unloaded descending phase **308** discussed in reference to at least FIGS. 4-7, the fuel cell controller **202** and the battery controller **204** may be configured to operate the plurality of fuel cell modules **14** and the plurality of battery packs **158,** respectively, to cause the traction motor **162** to transfer regenerative braking energy to the plurality of battery packs **158.** In response to capturing all available regenerative braking energy in the plurality of battery packs **158,** the fuel cell controller **202** may be configured to initiate or resume transferring energy from the plurality of fuel cell modules **14** to charge the plurality of battery packs **158.**

Other example operating states of the fuel cell vehicle **100** include a cold start operating state such as when the vehicle **100** operates in ambient temperature less than a predefined threshold temperature requiring an additional heating load and, thus, causing an increase in power demand on the plurality of fuel cell modules **14** and the plurality of battery packs **158.** As another example, activating a component protection mode such as, for example, initiating a hot shutdown to turn off power components, may, nevertheless, require the plurality of fuel cell modules **14** and/or the plurality of battery packs **158** to provide power to cool these power components and other components of the vehicle **100.** As still another example, additional charging of the plurality of battery packs **158** may be needed through the plurality of fuel cell modules **14** while the vehicle **100** is in an off state. As yet another example, test modes may be incorporated to test component health that would impact the power flows especially as it relates to the vehicle **100** power demand P and load bank demand.

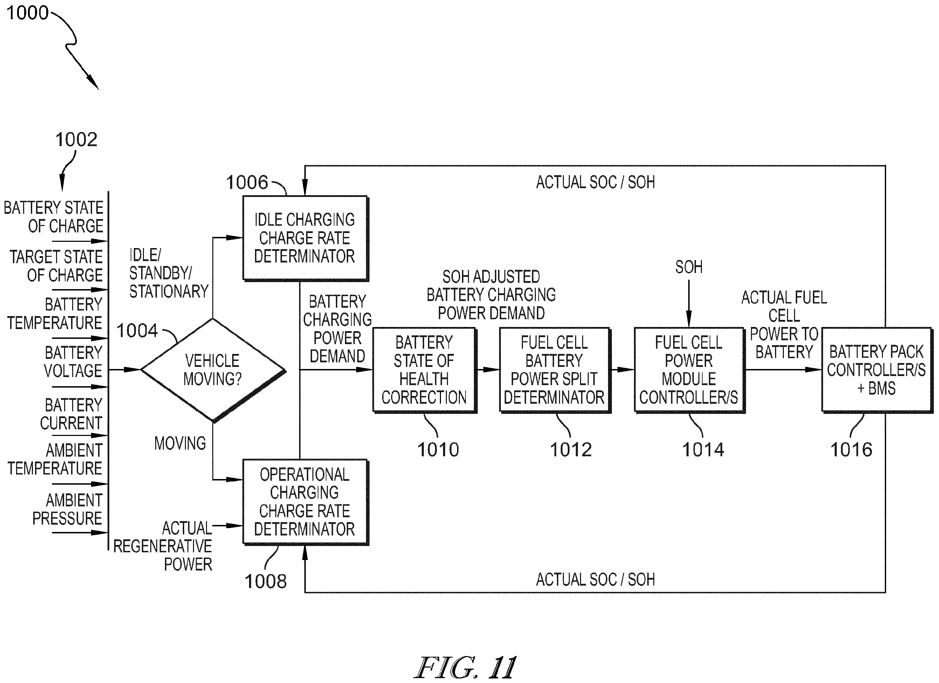

FIG. 11 illustrates an example power control system **1000** in accordance with the present disclosure. One or more operations of the control system **1000** may be executed by at least one of the fuel cell controller **202** and the battery controller **204.** Inputs **1002** to the control system **1000** of FIG. 11 include, for example, battery state of charge, target state of charge, battery temperature, battery voltage, battery current, ambient temperature, and/or ambient pressure. These inputs **1002** are inputs for at least one of the fuel cell controller **202** and the battery controller **204.**

At block **1004,** at least one of the fuel cell controller **202** and the battery controller **204** determine an operational state of the vehicle **100.** If the vehicle **100** is idle, standby, or stationary, at block **1006,** the at least one of the fuel cell controller **202** and the battery controller **204** determines a battery charge rate for charging the plurality of battery packs **158** while the vehicle **100** is idle, in standby, or stationary. The battery charge rate corresponds to the battery charging power demand. Block **1006** has an input of the SOC and SOH of the plurality of battery packs **158.** The SOH of the plurality of battery packs **158** is an input because, based on the SOH, a different charge rate and power demand may be used to extend the health of the plurality of battery packs **158.** A lookup table or a relational model may be used at block **1006** to determine the charge rate of the plurality of battery packs **158** with various SOCs and SOHs corresponding to charge rates.

If the vehicle **100** is determined to be moving at block **1004,** then at block **1008,** a battery charge rate for charging the plurality of battery packs **158** while the vehicle **100** is moving is determined. Block **1008** has an input of the SOC and SOH of the plurality of battery packs **158** and an actual regenerative power. The actual regenerative power is indicative of how much regenerative braking energy the traction motor **162** can transfer to the plurality of battery packs **158.**

For example, if the vehicle **100** is going down a hill, there may be regenerative power available for the plurality of battery packs **158** to use. As another example, if the vehicle **100** is going up a hill, there may be no regenerative power available for the plurality of battery packs **158** to use. The SOH of the plurality of battery packs **158** is an input because, based on the SOH, a different charge rate and power demand may be used to extend the health of the plurality of battery packs **158.** A lookup table or a relational model may be used at block **1008** to determine the charge rate of the plurality of battery packs **158** with various SOCs and SOHs and values of actual regenerative power corresponding to charge rates. The battery charge rate corresponds to the battery charging power demand from the plurality of fuel cell modules **14.**

At block **1010,** the at least one of the fuel cell controller **202** and the battery controller **204** corrects the plurality of battery packs **158** SOH by adjusting the power demand from the fuel cell modules **14** to charge the plurality of battery packs **158** to ensure the SOH of the plurality of battery packs **158** is not compromised. At block **1012,** the at least one of the fuel cell controller **202** and the battery controller **204** determines a power split between the fuel cell modules **14** and the plurality of battery packs **158.** At least one of the fuel cell controller **202** and the battery controller **204** determines the power split based on at least one of the SOH of the plurality of battery packs **158,** the SOH of the plurality of fuel cell modules **14,** and the SOC of the plurality of battery packs **158.**

At block **1014,** the fuel cell controller **202** operates the fuel cell modules **14** to provide power to the plurality of battery packs **158** to meet the power demand of the plurality of battery packs **158** based on the power split determined in block **1012.** The SOH of the plurality of fuel cell modules **14** may be used as an input to block **1014** to determine which fuel cell module(s) **14** will be used to charge the plurality of battery packs **158.** At block **1016,** the battery controller **204** operates the plurality of battery packs **158.**

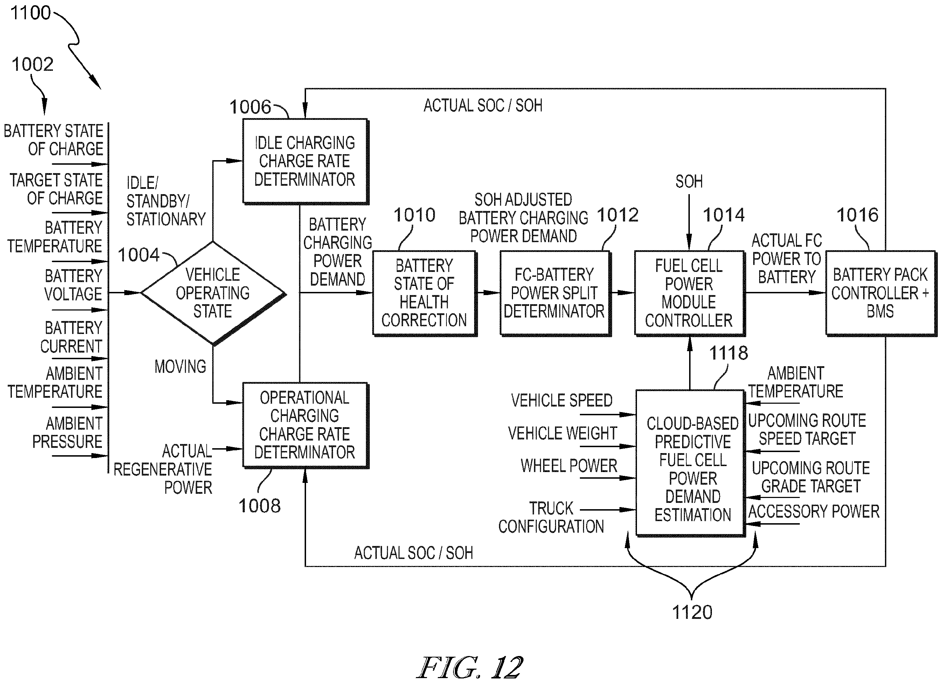

FIG. 12 illustrates another exemplary power control system **1100** configured to communicate with a cloud network **1118** to obtain data therefrom, such as, but not limited to, an estimated predictive fuel cell module power demand value for each fuel cell module **14** of the vehicle **100.** Power control system **1100** is identical to power control system **1000** except that power control system **1110** includes a cloud-based predictive fuel cell power demand estimation in block **1118.** Inputs **1120** to the cloud network in block **1118** include, for example, a speed of the vehicle **100,** a weight of the vehicle **100,** a power of the wheel **166,** a configuration of the vehicle **100,** such as, for example, bed heating, ambient temperature, upcoming route speed target, upcoming route grade target, and/or accessory power.

Inputs **1002** to the control system **1100** of FIG. 12 include, for example, battery state of charge, target state of charge, battery temperature, battery voltage, battery current, ambient temperature, and ambient pressure, among others. The inputs **1002** are inputs for at least one of the fuel cell controller **202** and the battery controller **204.** At block **1004,** at least one of the fuel cell controller **202** and the battery controller **204** determines the operational state of the vehicle **100.** If the vehicle **100** is idle, in standby, or stationary, at block **1006,** the at least one of the fuel cell controller **202** and the battery controller **204** determines a battery charge rate for charging the plurality of battery packs **158** while the vehicle **100** is idle, standby, or stationary. Block **1006** has an input of the SOC and SOH of the plurality of battery packs **158.** If the vehicle **100** is moving, at block **1008,** a battery charge rate for charging the plurality of battery packs **158** while the vehicle **100** is moving is determined. Block **1108** has an input of the SOC and SOH of the plurality of battery packs **158** and the actual regenerative power.

At block **1010,** the at least one of the fuel cell controller **202** and the battery controller **204** corrects the plurality of battery packs **158** SOH by adjusting the power demand from the fuel cell modules **14** to charge the plurality of battery packs **158** to ensure the SOH of the plurality of battery packs **158** is not compromised. At block **1012,** the at least one of the fuel cell controller **202** and the battery controller **204** determines a power split between the fuel cell modules **14** and the plurality of battery packs **158.** At least one of the fuel cell controller **202** and the battery controller **204** determines the power split based on at least one of the SOH of the plurality of battery packs **158,** the SOH of the plurality of fuel cell modules **14,** and the SOC of the plurality of battery packs **158.** At block **1014,** the fuel cell controller **202** operates the fuel cell modules **14** to provide power to the plurality of battery packs **158** to meet the power demand of the plurality of battery packs **158.** The SOH of the plurality of fuel cell modules **14** may be used as an input to block **1014** to determine which fuel cell module(s) **14** will be used to charge the plurality of battery packs **158.**

Block **1014** receives input from block **1118** regarding the estimated predictive fuel cell module power demand value for each fuel cell module **14.** For example, block **1118** may determine that a steep hill is in the upcoming route of the vehicle **100,** meaning the power demand P of the vehicle **100** will be increasing when the vehicle **100** encounters the hill. To prepare to encounter the hill, the plurality of battery packs **158** will be charged more by the plurality of fuel cell modules **14.** The fuel cell controller **202,** at block **1014,** uses the predictive information from block **1118** to provide power to the plurality of battery packs **158** from the plurality of fuel cell modules **14.** At block **1016,** the battery controller **204** operates the plurality of battery packs **158.**

As described above, an example fuel cell vehicle **100** for specialized off-highway/on-highway applications, such as mining or power generation, may include the plurality of fuel cell modules **14** (that, in turn, may be arranged into the plurality of fuel cell stacks **12)** and/or the plurality of battery packs **158.** In some instances, portions (e.g., cells, modules of cells) of the battery pack **158** or one or more battery packs **158** of the fuel cell vehicle **100** may be replaced at different times, such that a battery energy system of a given fuel cell vehicle **100** may include battery packs **158** or portions of battery packs **158** that have different ages and, thus, different SOH.

The system of the present disclosure uses dynamic control algorithms to optimize fuel cell **20** operation by controlling the operating point of each fuel cell module **14** individually to achieve a globally optimum fuel consumption(see e.g., FIG. 2B). An example fuel cell module **14** configuration includes a plurality of fuel cell modules **14,** each having either the same or different power ratings from one another, being connected to a main DC bus **168** of an electrified powertrain **100.** The powertrain **100** connection may be through a DC link connecting the traction motor generators (e.g., the traction motor **162),** or through a single motor generator driving transmission and/or axle. Indeed, these arrangements may be applicable to a fuel cell hybrid architecture having a battery in the system.

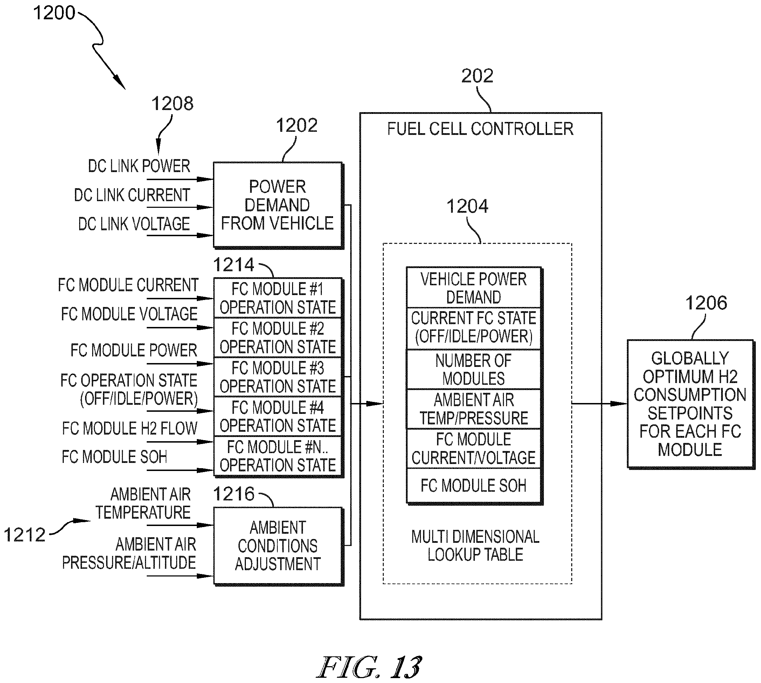

As illustrated in at least FIGS. 13-16, the system of the present disclosure includes the fuel cell controller **202** configured to apply one of an open loop control strategy **1200,** a closed loop control strategy **1300,** a hybrid control strategy **1400,** and/or an additional hybrid control strategy **1500** that includes elements of both the open and closed loop strategies.

FIG. 13 illustrates an example open loop control strategy system **1200** for the fuel cell vehicle **100.** In one example, an open loop control strategy may be implemented by the fuel cell controller **202** and may include a split main DC link power demand from the vehicle **100** based on fixed calibration with a multi-dimensional lookup table utilized by an open loop controller **1204.** The fuel cell controller **202** includes the open loop controller **1204.**

Inputs **1208** are used to determine the power demand P of the vehicle **100** in block **1202.** Inputs **1208** include a DC link power, a DC link current, and a DC link voltage. Inputs **1210** are received by block **1214** which determines an operation state of each fuel cell module **14.** Inputs **1210** include a current, a voltage, a power, an operation state (off/idle/powered), a SOH, and a fuel flow of each fuel cell module **14.** Block **1216** determines changes in ambient conditions. Inputs **1212** of block **1216** include ambient air temperature and ambient air pressure and/or altitude.

Fuel cell controller **202** receives information regarding the power demand P of the vehicle **100** from block **1202,** the operation state of each fuel cell module **14** from block **1214,** and/or information regarding ambient conditions from block **1216.** The fuel cell controller **202** is configured to interpolate values that fall between those available in the lookup table of the open loop controller **1204,** where the lookup table may be a calibration set based on detailed test data generation stored in the fuel cell controller **202** during manufacturing. Using the information received from blocks **1202, 1214,** and **1216,** and the lookup table of the open loop controller **1204,** the fuel cell controller **202** determines and outputs an operating point of each fuel cell module **14** individually to achieve a globally optimum fuel consumption in block **1206.**

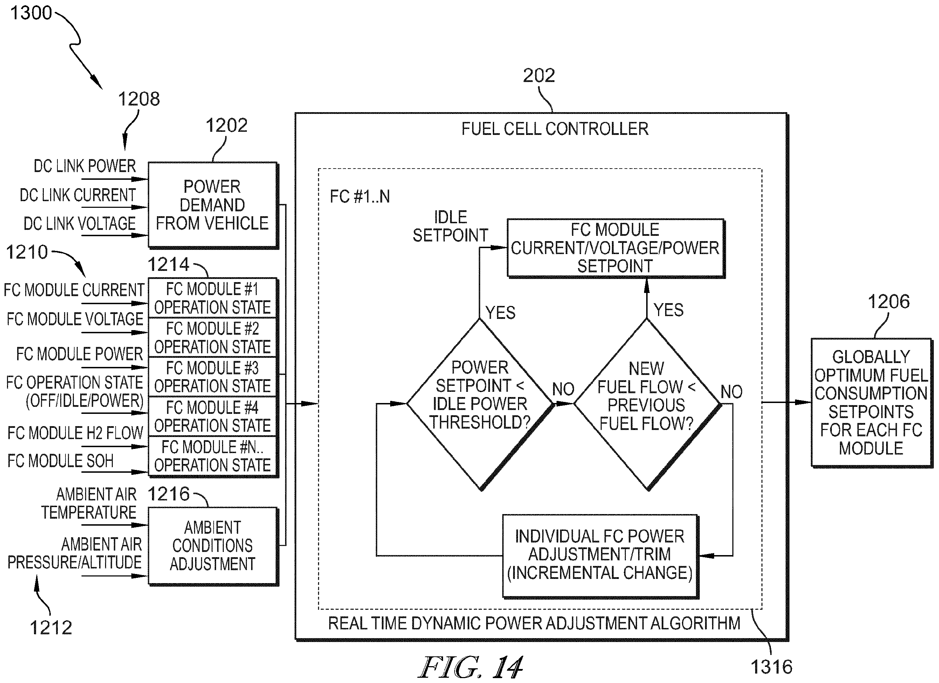

FIG. 14 illustrates an example closed loop control strategy system **1300** in accordance with the present disclosure. In applying a closed loop control strategy, the fuel cell controller **202** is configured to provide a dynamic power demand split into individual fuel cell modules **14** and control power flow to meet an overall system optimum for fuel cell fuel consumption. The closed loop control strategy system **1300** is similar to the open loop control strategy system **1200,** except that the closed loop control strategy system **1300** utilizes a closed loop controller **1316** including a real time dynamic power adjustment algorithm instead of the multi-dimensional lookup table of the open loop controller **1204.**

Inputs **1208** in applying the closed loop control strategy are the same inputs **1208** as in the open loop control strategy system **1200** (a DC link power, a DC link power current, and a DC link power voltage). Inputs **1208** are used to determine the power demand P of the vehicle **100** in block **1202.** Inputs **1210** are received by block **1214** to determine an operation state of each fuel cell module **14.** Inputs **1210** include a current, a voltage, a power, an operation state (off/idle/powered), a SOH, and a fuel flow of each fuel cell module **14.** Block **1216** determines any changes in ambient conditions. Inputs **1212** of block **1216** include ambient air temperature and ambient air pressure/altitude.

Fuel cell controller **202** receives information regarding the power demand P of the vehicle **100** from block **1202,** an operation state of each fuel cell module **14** from block **1214,** and information regarding ambient conditions from block **1216.** The closed loop controller **1316** uses the real time dynamic power adjustment algorithm to set a current, voltage, and power of each fuel cell module **14** based on real-time data and/or information. Outputs of the closed loop strategy include optimum fuel cell fuel consumption set points **1206** for each fuel cell module **14,** such as voltage, current, and power for each fuel cell module **14.**

In applying the closed loop strategy, the fuel cell controller **202** may be configured to minimize overall fuel cell fuel consumption, and, at the fuel cell module **14** level, change power levels at each of the modules **14.** In this manner, the fuel cell controller **202** is configured to minimize overall system fuel cell fuel consumption by actively changing a power output, e.g., current and voltage, at each of the fuel cell modules **14.** Further, during closed loop control, each fuel cell module **14** may be placed in an "idle" operating mode/state in response to a signal or command indicating an increase in power demand P such that overall fuel cell fuel consumption of the vehicle **100** increases.

The closed loop controller **1316** determines a power set point for each fuel cell module **14** based on the information from blocks **1202, 1214,** and **1216.** Then, the closed loop controller **1316** performs a check on the power set point before outputting a globally optimum fuel consumption set point in block **1206.** To determine the globally optimum fuel consumption set point, the closed loop controller **1316** determines whether the power set point is less than an idle power threshold. If the power set point is less than the idle power threshold, the fuel cell module **14** is in an idle state. If the fuel cell module **14** is in the idle state, then the controller **1316** updates the idle power threshold to correspond to the power set point and outputs the globally optimum fuel consumption set point for the fuel cell module **14,** corresponding to block **1206.**

If the power set point is greater than the idle power threshold, the controller **1316** determines whether a new fuel flow based on the power set point is less than a previous fuel flow based on the idle power threshold. If the previous fuel flow is greater than the new fuel flow, then the controller updates the idle power threshold to the power set point. The controller **1316** then outputs the globally optimum fuel consumption set point for the fuel cell module **14,** corresponding to block **1206.** If the previous fuel flow is less than the new fuel flow, then the controller **1316** performs an incremental adjustment of the power set point corresponding to an updated power set point. The closed loop controller **1316** then determines whether the updated power set point is less than the idle power threshold and the process continues until the idle power threshold is greater than the updated power set point.

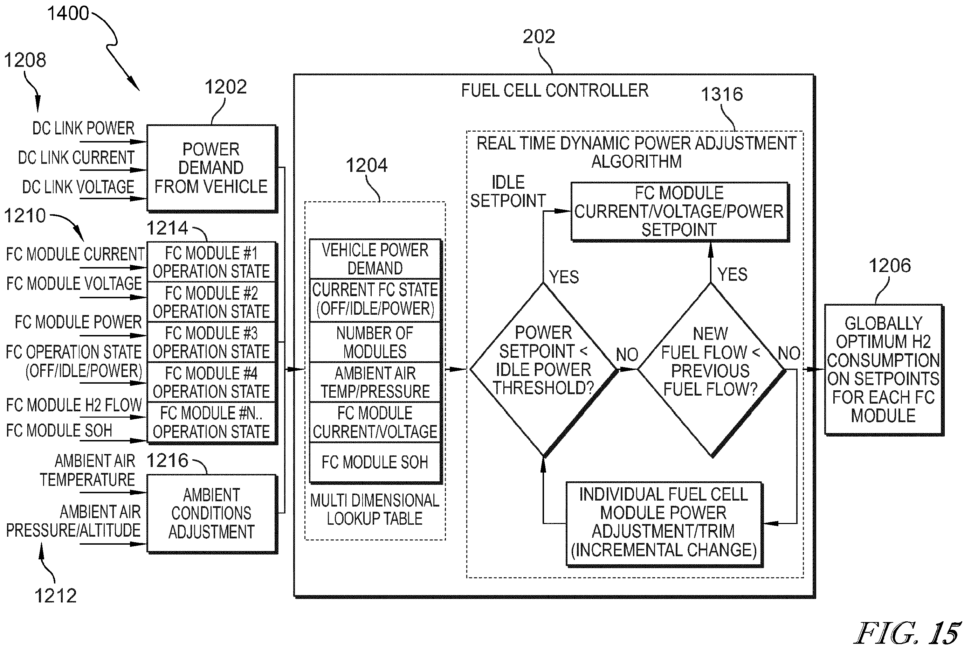

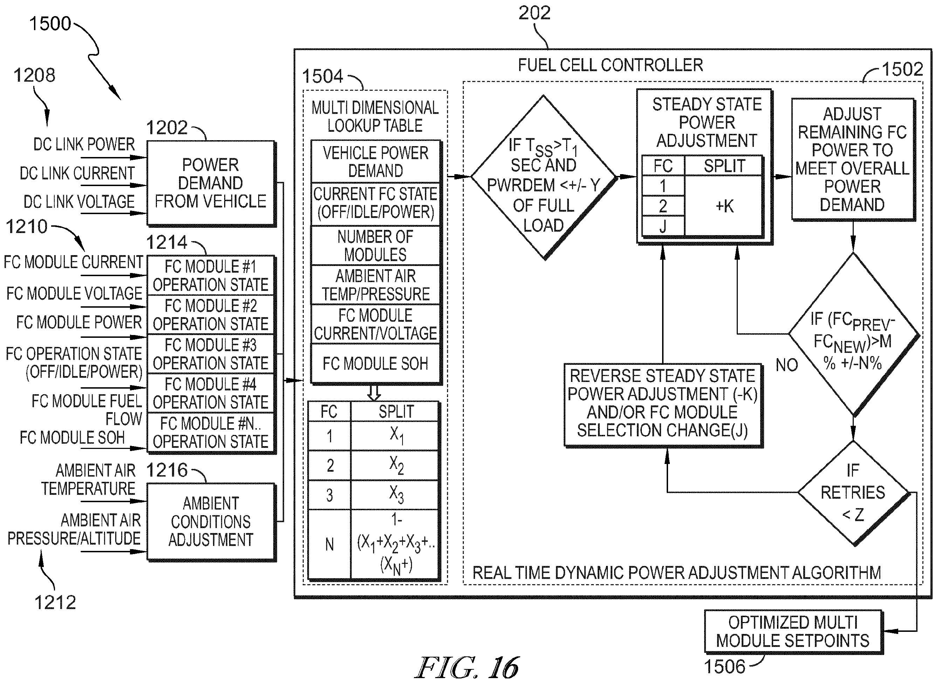

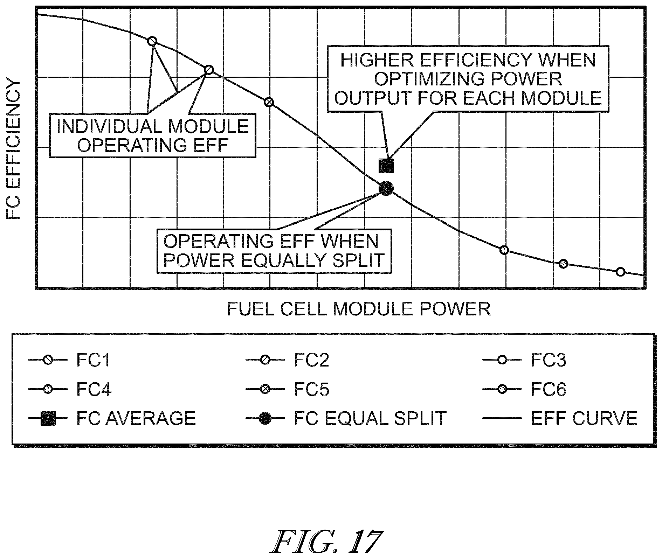

FIGS. 15 and 16 illustrate example hybrid control strategy systems **1400** and **1500,** respectively, in accordance with the present disclosure. In applying the hybrid control strategy, the fuel cell controller **202** includes the closed loop controller **1316,** as discussed in reference to FIG. 14, operating in conjunction with the open loop controller **1204,** as discussed in reference to FIG. 13, to achieve an optimized operating mode. Thus, the fuel cell vehicle **100** including individual fuel cell modules **14** of either the same or different power ratings may achieve optimal operation (see, e.g., FIG. 17).

In one example, the open loop controller **1204** uses a static lookup of the power demand split between the fuel cell modules **14** based on the multi-dimensional table or relationship. Once static set points are made, the closed loop controller **1316** activates in response to the global power demand operating within a threshold of a steady state for a predefined time period. In this manner, the fuel cell controller **202** ensures further optimization of the fuel cell power set points at steady state. The fuel cell controller **202** is configured to make a predetermined power adjustment to a selected number of fuel cell modules **14** and check for improvement of overall fuel consumption numbers beyond a variation band. By performing this check, the fuel cell controller **202** ensures fuel consumption benefits can be detected and are not part of the 'noise'. In response to detecting that the global fuel consumption improved, the fuel cell controller **202** is configured to continue refining the power set points until there is no more improvement to be made. In response to detecting that the fuel consumption did not improve, the fuel cell controller **202** is configured to reverse a last power adjustment and/or reverse power adjustment in the selected fuel cell modules **14.** The fuel cell controller **202** may be configured to repeat for a predetermined number of computational cycles or period of time prior to finalizing a fixed set of power set points for the individual fuel cell modules **14.**

In applying the hybrid control strategy of FIG. 16, the fuel cell controller **202** includes a closed loop controller **1502** operating in conjunction with an open loop controller **1504** to achieve an optimized operating mode. The open loop controller **1504** determines a power set point for each fuel cell module **14** based on the information from blocks **1202, 1214,** and **1216.** The closed loop controller **1502** then checks the power set point of each fuel cell module **14** to output an optimized multi-module set point in block **1506.**

Hybrid control strategy **1500** allows idling between different fuel cell modules **14.** Each fuel cell module **14** may provide a different amount of power to meet the power demand P of the vehicle **100.** The strategy **1500** cycles between using different fuel cell modules **14** and/or adjusting the power from each fuel cell module **14** based on the SOH of each fuel cell module **14.** The cycling minimizes the aging of one fuel cell module **14** over another fuel cell module **14.**

If a time counter (*T_{SS}*) is greater than a calibratable time constant (*T*₁), and the power demand of the fuel cell module **14** based on the power set point from the open loop controller **1504** (PwrDem) is less than a power demand variation band (Y), then the power set point of the fuel cell module **14** will be adjusted. Based on the power demand P of the vehicle **100,** and the adjusted power set point of the fuel cell module **14,** the power set point of the remaining fuel cell modules **14** will then be adjusted to meet the overall power demand P of the vehicle **100.**

*T_{SS}* is representative of a time counter for steady state power demand. *T*₁ is representative of a calibratable time constant. PwrDem is representative of an instantaneous power demand. Y is representative of a power demand variation band and may be implemented as an absolute value or relative percent. J is a selected fuel cell module **14** for steady state power adjustment. K is representative of a steady state power demand adjustment for each fuel cell module **14.** FCPREV and FCNEW are representative of a previous and new fuel consumption values, respectively. Z is representative of a retry count and may be implemented as a time period, such as by providing a clock signal.

FIG. 17 is a graph illustrating a change in fuel efficiency of the plurality of fuel cell modules **14** with respect to a change in fuel cell module power. Higher efficiency is achieved when power output is optimized for each fuel cell module **14.**

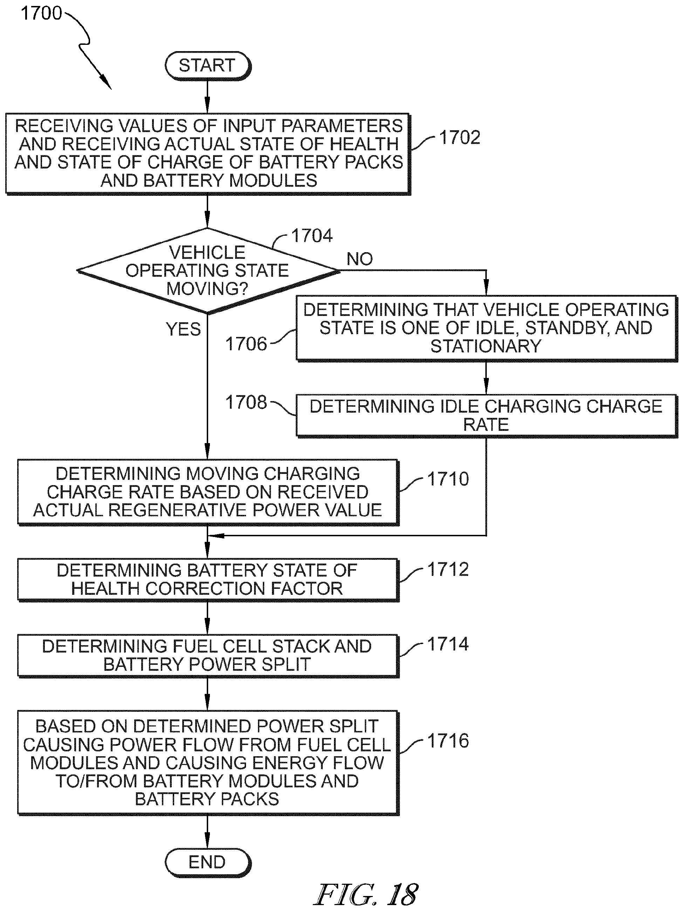

FIG. 18 illustrates an example process **1700** for controlling power flow from the plurality of fuel cell modules **14** and to and from the plurality of battery packs **158.** One or more operations of the process **1700** may be executed by one of the fuel cell controllers **202.** In other instances, one or more operations of the process **1700** may be executed by the fuel cell controller **202** and/or the battery controller **204** or by another one or more controller(s) of the fuel cell vehicle **100.**

The process **1700** may begin at block **1702** where the fuel cell controller **202** receives values of one or more input parameters, such as, for example, actual battery SOC, target battery SOC, battery temperature, battery voltage, battery current, ambient temperature, and ambient pressure. In some instances, the fuel cell controller **202** is configured to receive actual SOH and SOC of the plurality of battery packs **158** and/or battery modules of the plurality of battery packs **158.**

At block **1704** the fuel cell controller **202** determines whether the operating state of the fuel cell vehicle **100** is a moving state. In response to determining that the vehicle **100** is not moving, the fuel cell controller **202,** at block **1706,** determines that the operating state of the fuel cell vehicle **100** is one of an idle state, a standby state, and a stationary state. The fuel cell controller **202,** at block **1708,** determines an idle charging charge rate for the plurality of battery packs **158.** In response to determining that the operating state of the vehicle **100** is a moving state, the fuel cell controller **202,** at block **1710,** determines a moving charging charge rate based on the received input parameter values and/or a received actual regenerative power value.

At block **1712,** the fuel cell controller **202** determines a battery SOH correction factor. In one example, the fuel cell controller **202** may be configured to determine a battery SOH correction factor in accordance with one or more operations described in reference to FIGS. 13-16. At block **1714,** the fuel cell controller **202** is configured to determine, based on the determined battery SOH correction factor, a power split between the plurality of fuel cell modules **14** and the plurality of battery packs **158.**

At block **1716,** the fuel cell controller **202** causes a flow of power and energy from the plurality of fuel cell modules **14** and to and from the plurality of battery packs **158** (including to and from individual modules of the plurality of battery packs **158)** to meet power demand P of the vehicle **100** and/or to maintain the SOC of the plurality of battery packs **158.** In one example, the fuel cell controller **202** causes a flow of power and energy based on and according to the determined power split. The process **1700** may then end. In some instances, the process **1700** may be repeated in response to receiving values of a plurality of input parameters and actual SOH and SOC of the plurality of battery packs **158** and/or battery modules or in response to another signal or command.

The system of the present disclosure is configured to apply a prioritization strategy to charge each of the plurality of battery packs **158** (or battery modules of each of the plurality of battery packs **158),** where the SOH of at least one of the plurality of battery packs **158** (or battery modules of each of the plurality of battery packs **158)** is different from the SOH of one or more other battery packs **158** of the plurality of battery packs **158** (or the SOH of at least one of a plurality of battery modules of at least one of the plurality of battery packs **158** is different from the SOH of one or more other battery modules of a same battery pack **158** or different battery packs **158).** In one example, the system is configured to prioritize using battery packs **158** having a higher SOH, rather than battery packs **158** having a lower SOH to mitigate degradation of battery packs **158** that are farther along an aging continuum.

The system of the present disclose may be configured to determine a load/future load based on a specific duty cycle or lookahead data. The system may be configured to communicate that load to a corresponding controller, e.g., the battery controller **204,** the fuel cell controller **202,** and so on. The controller **202, 204** may be configured to rank each of the plurality of battery packs **158** with respect to one another based on SOH and/or SOC of that battery pack **158.** In one example, the controller **202, 204** may be configured to prioritize meeting a present power load using energy of the plurality of battery packs **158** (and battery pack modules) having the highest SOH and having a SOC greater then a threshold over the plurality of battery packs **158** having a lower SOH.

To meet the demanded power load, the controller **202, 204** is configured to adjust the discharge rates from the plurality of battery packs **158** based on the SOH of those battery packs **158.** In some instances, the controller **202, 204** may be configured to use one or more of the fuel cell modules **14** not being used to meet the demanded power load to charge the unused battery packs 158. The controller **202, 204** is configured to sequence and/or prioritize the charging of the unused battery packs **158** based on the SOH and SOC of that battery pack **158** (or one or more battery modules of that battery pack **158** or other battery packs **158** of the system) and/or based on vehicle lookahead data.

In this manner, the system is configured to use vehicle lookahead data and the battery packs **158** and battery modules having a different SOH to split the power to the battery packs **158** as a function of instantaneous load to achieve a predefined mission horizon. For example, in response to detecting that the vehicle **100** will operate in a regenerative mode, *i.e.,* more throughput (based on mass and route), the system may be configured to prioritize using the battery packs **158** having a high SOH and using the battery packs **158** having a lower SOH during other operating modes. The controller **202, 204** is configured to adjust operating conditions to affect aging of the battery packs **158** to align with a common service/rebuild interval or one that is preferred by the end user. The battery management system is configured to modify power capability of each subsystem by, for example, modifying charging rates of battery packs **158** having a lower SOH, to meet the power demand P of the vehicle **100** using a different/modified power split under different operating conditions.

The controller **202, 204** may be configured to rank each of the plurality of fuel cell modules **14** based on a value of the SOH of each of the plurality of fuel cell modules **14,** e.g., with the fuel cell module **14** having a largest value of SOH or having a SOH greater than a first predefined threshold being ranked first, another fuel cell module **14** having a second largest value of SOH or having a SOH greater than a second predefined threshold and less than the first predefined threshold being ranked below the first rank, and so on. In response to detecting that the power demand P of the vehicle **100** may be met by a subset of (e.g., fewer than all and including one) the fuel cell modules **14,** the controller **202, 204** may be configured to cause the power demand P of the vehicle **100** to be met using the fuel cell module **14** (or one or more fuel cell stacks **12** of the same or different fuel cell modules **14)** having a greater SOH, e.g., the greatest value of SOH or ranked first, the second greatest value of SOH or ranked second or below the first, based on the rank by SOH, as described above.

In another example, in response to detecting that the power demand P of the vehicle **100** may be met by a subset of (i.e., fewer than all and including one) the fuel cell modules **14,** the controller **202, 204** may be configured to prioritize power demand P of the vehicle **100** to be met (i.e., power provided) by the fuel cell modules **14** having a higher SOH ranking. In response to the SOC of the plurality of battery packs **158** being less than a predefined threshold, the controller **202, 204** may be configured to cause one or more of the plurality of fuel cell modules **14** having a SOH less than a predefined threshold (including, for example, the fuel cell modules **14** having a lowest SOH) and currently not providing power to the vehicle **100** to charge the battery packs **158.** Using a subset of the plurality of fuel cell modules **14** having a SOH rank less than a threshold rank, the controller **202, 204** may be configured to charge the battery packs **158** at a constant rate to improve the life of the fuel cell modules **14.** The controller **202, 204** may prioritize charging of these battery packs **158** based on a SOH of the fuel cell modules **14** and/or the SOC and SOH of the plurality of battery packs **158.** For example, the controller **202, 204** is configured to use one or more of the plurality of fuel cell modules **14** that are not supplying power (e.g., are idle) to the vehicle **100** to charge one or more of the plurality of battery packs **158** having the lowest SOC.

Benefits of the system of the present disclosure include ensuring a target SOC of the battery pack **158** is maintained so that sufficient energy and power from the battery pack **158** can be provided during sustained power demand situations. The system provides optimizing fuel cell **20** and battery **158** component sizing leading to a significant reduction on cost of the system. The system provides significant reduction in operational costs to a vehicle operator by optimizing fuel consumption from the fuel cell modules **14** by ensuring an optimal battery SOC. The disclosed system may be used in conjunction with the fuel cell-battery power split controller **202, 204** to further optimize fuel consumption and reduce operating costs. The system improves component life of the fuel cell modules **14** by reducing transient power demand on the fuel cell modules **14** and improving component life of the battery packs **158** by compensating based on a SOH of one or more components of the battery packs **158.**

The following described aspects of the present invention are contemplated and nonlimiting:
A first aspect of the present invention relates to a system for a fuel cell vehicle. The system comprises a plurality of fuel cell modules, a plurality of battery packs, and a controller. At least one of the plurality of fuel cell modules has a state of health (SOH) different from a corresponding SOH of another fuel cell module in the plurality of fuel cell modules. Each battery pack includes a plurality of battery cells. At least one of the plurality of battery packs has a SOH different from a corresponding SOH of another battery pack in the plurality of battery packs. The controller is communicatively coupled to the plurality of fuel cell modules and the plurality of battery packs. The controller is configured to monitor and control operation of the plurality of fuel cell modules or the plurality of battery packs. The controller is configured to receive a power demand of the vehicle. The controller is configured to determine a power split between the plurality of fuel cell modules and the plurality of battery packs based on an operating phase of the vehicle. The controller is configured to cause a flow of power based on a determined power split from the plurality of fuel cell modules and from the plurality of battery packs to meet the power demand.

A second aspect of the present invention relates to a method for a fuel cell vehicle. The method comprises receiving a plurality of input parameters, an actual state of health (SOH) of a battery, and a state of charge (SOC) of the battery, determining an operating state of the vehicle, determining a battery SOH correction factor, determining a power split between a plurality of fuel cell modules and the battery, and causing a flow of power from the plurality of fuel cell modules and to and from the battery based on the determined power split.

According to a third aspect, described herein, a system for a fuel cell vehicle comprises a plurality of fuel cell modules, a plurality of battery packs, and a controller. Each fuel cell module of the plurality of fuel cell modules includes a plurality of fuel cell stacks. Each battery pack of the plurality of battery packs includes a plurality of battery modules. At least one of the plurality of battery modules has a state of health (SOH) different from a corresponding SOH of another battery module in the plurality of battery modules. The controller is communicatively coupled to monitor and control operation of the plurality of fuel cell modules and the plurality of battery packs. The controller is configured to receive a power demand. The controller is configured to determine a power set point for each of the plurality of fuel cell stacks of each of the plurality of fuel cell modules. The controller is configured to cause a flow of power from each of the plurality of fuel cell stacks of each of the plurality of fuel cell modules based on the determined power set point of each of the plurality of fuel cell stacks.

In the first aspect of the present invention, the controller may be configured to determine the power split based on at least one of the SOH of the plurality of battery packs, the SOH of the plurality of fuel cell modules, and a state of charge (SOC) of the plurality of battery packs. In the first aspect of the present invention, the plurality of battery cells may be combined to provide a plurality of battery modules, and wherein a SOH of at least one of the plurality of battery modules may be different from a SOH of at least one other of the plurality of battery modules.

In the first aspect of the present invention, the controller may be configured to, in response to the power demand being greater than a threshold, determine an even power split between the plurality of fuel cell modules and the plurality of battery packs and cause the flow of power from the plurality of fuel cells modules and the plurality of battery packs to power a traction motor to propel the vehicle. In the first aspect of the present invention, the controller may be configured to, in response to input parameters, determine a vehicle operational state, determine a battery power rate based on a relational or lookup model, and cause at least one of the events of powering a traction motor to propel the vehicle, powering vehicle accessory systems, or causing the plurality of fuel cell modules to charge the plurality of battery packs.

In the first aspect of the present invention, the controller may be configured to cause the plurality of fuel cell modules to charge the plurality of battery packs further in response to detecting a truck bed of the vehicle is active. In the first aspect of the present invention, the controller may be configured to determine a battery SOH correction factor to be used in determining the power split between the plurality of fuel cell modules and the plurality of battery packs.

In the second aspect of the present invention, the method may further comprise, in response to determining that the operating state of the vehicle is one of an idle state, a standby state, or a stationary state, determining a battery charge rate for charging the battery while the vehicle is in the idle state, the standby state, or the stationary state. In the second aspect of the present invention, the method may further comprise in response to determining that the operating state of the vehicle is a moving state, determining a battery charge rate for charging the battery while the vehicle is moving.

In the second aspect of the present invention, the plurality of input parameters may include one of an actual battery SOC, a target battery SOC, a battery temperature, a battery voltage, a battery current, an ambient temperature, and an ambient pressure. In the second aspect of the present invention, the power split may be determined based on a predictive fuel cell power demand estimation. In the second aspect of the present invention, the predictive fuel cell power demand estimation may be provided by a cloud-based analytical system. In the second aspect of the present invention, the cloud-based analytical system may determine the predictive fuel cell power demand estimation based on values of one of a speed of the vehicle, a weight of the vehicle, a wheel power, a configuration of the vehicle, an ambient temperature, an upcoming route target speed, an upcoming route target grade, or an accessory power.

In the third aspect of the present invention, to determine the corresponding power set point may include to determine whether the determined power set point is less than an idle power threshold, and wherein the controller may be configured to, in response to the determined power set point being less than the idle power threshold, update a value of the idle power threshold to correspond to a value of the determined power set point. In the third aspect of the present invention, the controller may be configured to, in response to the determined power set point being greater than the idle power threshold, determine whether a new fuel flow based on the determined power set point is less than a previous fuel flow based on the idle power threshold.

In the third aspect of the present invention, the controller may be configured to, in response to the new fuel flow based on the determined power set point being less than the previous fuel flow based on the idle power threshold, update the value of the idle power threshold to correspond to the value of the determined power set point. In the third aspect of the present invention, the controller may be configured to, in response to the new fuel flow based on the determined power set point being greater than the previous fuel flow based on the idle power threshold, incrementally adjust the determined power set point to correspond to an updated determined power set point.

The features illustrated or described in connection with one exemplary embodiment may be combined with any other feature or element of any other embodiment described herein. Such modifications and variations are intended to be included within the scope of the present disclosure. Further, a person skilled in the art will recognize that terms commonly known to those skilled in the art may be used interchangeably herein.

The above embodiments are described in sufficient detail to enable those skilled in the art to practice what is claimed and it is to be understood that logical, mechanical, and electrical changes may be made without departing from the spirit and scope of the claims. The detailed description is, therefore, not to be taken in a limiting sense.

As used herein, an element or step recited in the singular and proceeded with the word "a" or "an" should be understood as not excluding plural of said elements or steps, unless such exclusion is explicitly stated. Furthermore, references to "one embodiment" of the presently described subject matter are not intended to be interpreted as excluding the existence of additional embodiments that also incorporate the recited features. Specified numerical ranges of units, measurements, and/or values comprise, consist essentially or, or consist of all the numerical values, units, measurements, and/or ranges including or within those ranges and/or endpoints, whether those numerical values, units, measurements, and/or ranges are explicitly specified in the present disclosure or not.

Unless defined otherwise, technical and scientific terms used herein have the same meaning as is commonly understood by one of ordinary skill in the art to which this disclosure belongs. The terms "first," "second," "third" and the like, as used herein do not denote any order or importance, but rather are used to distinguish one element from another. The term "or" is meant to be inclusive and mean either or all of the listed items. In addition, the terms "connected" and "coupled" are not restricted to physical or mechanical connections or couplings, and can include electrical connections or couplings, whether direct or indirect.

Moreover, unless explicitly stated to the contrary, embodiments "comprising," "including," or "having" an element or a plurality of elements having a particular property may include additional such elements not having that property. The term "comprising" or "comprises" refers to a composition, compound, formulation, or method that is inclusive and does not exclude additional elements, components, and/or method steps. The term "comprising" also refers to a composition, compound, formulation, or method embodiment of the present disclosure that is inclusive and does not exclude additional elements, components, or method steps.

The phrase "consisting of" or "consists of" refers to a compound, composition, formulation, or method that excludes the presence of any additional elements, components, or method steps. The term "consisting of" also refers to a compound, composition, formulation, or method of the present disclosure that excludes the presence of any additional elements, components, or method steps.

The phrase "consisting essentially of" or "consists essentially of" refers to a composition, compound, formulation, or method that is inclusive of additional elements, components, or method steps that do not materially affect the characteristic(s) of the composition, compound, formulation, or method. The phrase "consisting essentially of" also refers to a composition, compound, formulation, or method of the present disclosure that is inclusive of additional elements, components, or method steps that do not materially affect the characteristic(s) of the composition, compound, formulation, or method steps.

Approximating language, as used herein throughout the specification and claims, may be applied to modify any quantitative representation that could permissibly vary without resulting in a change in the basic function to which it is related. Accordingly, a value modified by a term or terms, such as "about," and "substantially" is not to be limited to the precise value specified. In some instances, the approximating language may correspond to the precision of an instrument for measuring the value. Here and throughout the specification and claims, range limitations may be combined and/or interchanged. Such ranges are identified and include all the sub-ranges contained therein unless context or language indicates otherwise.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances, the modified term may sometimes not be appropriate, capable, or suitable.

It is to be understood that the above description is intended to be illustrative, and not restrictive. For example, the above-described embodiments (and/or aspects thereof) may be used individually, together, or in combination with each other. In addition, many modifications may be made to adapt a particular situation or material to the teachings of the subject matter set forth herein without departing from its scope. While the dimensions and types of materials described herein are intended to define the parameters of the disclosed subject matter, they are by no means limiting and are exemplary embodiments. Many other embodiments will be apparent to those of skill in the art upon reviewing the above description. The scope of the subject matter described herein should, therefore, be determined with reference to the appended claims, along with the full scope of equivalents to which such claims are entitled.

This written description uses examples to disclose several embodiments of the subject matter set forth herein, including the best mode, and also to enable a person of ordinary skill in the art to practice the embodiments of disclosed subject matter, including making and using the devices or systems and performing the methods. The patentable scope of the subject matter described herein is defined by the claims, and may include other examples that occur to those of ordinary skill in the art. Such other examples are intended to be within the scope of the claims if they have structural elements that do not differ from the literal language of the claims, or if they include equivalent structural elements with insubstantial differences from the literal languages of the claims.

While only certain features of the invention have been illustrated and described herein, many modifications and changes will occur to those skilled in the art. It is, therefore, to be understood that the appended claims are intended to cover all such modifications and changes as fall within the scope of the invention.

## Claims

1. A system for a fuel cell vehicle, the system comprising:
a plurality of fuel cell modules, at least one of the plurality of fuel cell modules having a state of health (SOH) different from a corresponding SOH of another fuel cell module in the plurality of fuel cell modules;
a plurality of battery packs, each battery pack including a plurality of battery cells, at least one of the plurality of battery packs having a SOH different from a corresponding SOH of another battery pack in the plurality of battery packs; and
a controller communicatively coupled to the plurality of fuel cell modules and the plurality of battery packs, the controller being configured to:
monitor and control operation of the plurality of fuel cell modules or the plurality of battery packs,
receive a power demand of the vehicle,
determine a power split between the plurality of fuel cell modules and the plurality of battery packs based on an operating phase of the vehicle, and
cause a flow of power based on a determined power split from the plurality of fuel cell modules and from the plurality of battery packs to meet the power demand.

2. The system of claim 1, wherein the controller is configured to determine the power split based on at least one of the SOH of the plurality of battery packs, the SOH of the plurality of fuel cell modules, and a state of charge (SOC) of the plurality of battery packs.

3. The system of claim 1 or 2, wherein the plurality of battery cells are combined to provide a plurality of battery modules, and wherein a SOH of at least one of the plurality of battery modules is different from a SOH of at least one other of the plurality of battery modules.

4. The system of any preceding claim, wherein the controller is configured to, in response to the power demand being greater than a threshold, determine an even power split between the plurality of fuel cell modules and the plurality of battery packs and cause the flow of power from the plurality of fuel cell modules and the plurality of battery packs to power a traction motor to propel the vehicle.

5. The system of claim 4, wherein the even power split is determined in further response to detecting that the vehicle is moving up an incline.

6. The system of any preceding claim, wherein the controller is configured to, in response to input parameters, determine a vehicle operational state, determine a battery power rate based on a relational or lookup model, and cause at least one of the events of powering a traction motor to propel the vehicle, powering vehicle accessory systems, or causing the plurality of fuel cell modules to charge the plurality of battery packs.

7. The system of claim 6, wherein the controller is configured to cause the plurality of fuel cell modules to charge the plurality of battery packs further in response to detecting a truck bed of the vehicle is active.

8. The system of any preceding claim, wherein the controller is configured to determine a battery SOH correction factor to be used in determining the power split between the plurality of fuel cell modules and the plurality of battery packs.

9. A method for a fuel cell vehicle, the method comprising:
receiving a plurality of input parameters, an actual state of health (SOH) of a battery, and a state of charge (SOC) of the battery;
determining an operating state of the vehicle;
determining a battery SOH correction factor;
determining a power split between a plurality of fuel cell modules and the battery; and
causing a flow of power from the plurality of fuel cell modules and to and from the battery based on the determined power split.

10. The method of claim 9 further comprising, in response to determining that the operating state of the vehicle is one of an idle state, a standby state, or a stationary state, determining a battery charge rate for charging the battery while the vehicle is in the idle state, the standby state, or the stationary state.

11. The method of claim 9 or 10 further comprising, in response to determining that the operating state of the vehicle is a moving state, determining a battery charge rate for charging the battery while the vehicle is moving.

12. The method of any of claims 9 to 11, wherein the plurality of input parameters include one of an actual battery SOC, a target battery SOC, a battery temperature, a battery voltage, a battery current, an ambient temperature, and an ambient pressure.

13. The method of any of claims 9 to 12, wherein the power split is determined based on a predictive fuel cell power demand estimation.

14. The method of claim 13, wherein the predictive fuel cell power demand estimation is provided by a cloud-based analytical system.

15. The method of claim 14, wherein the cloud-based analytical system determines the predictive fuel cell power demand estimation based on values of one of a speed of the vehicle, a weight of the vehicle, a wheel power, a configuration of the vehicle, an ambient temperature, an upcoming route target speed, an upcoming route target grade, or an accessory power.
